# EUROPEAN PATENT SPECIFICATION

(11) **EP 3 127 172 B1**
(45) Date of publication and mention of the grant of the patent: **19.08.2020**
(21) Application number: 15772971.6
(22) Date of filing: 01.04.2015
(51) Int. Cl.: G01R 15/14, H01L 41/04, H01L 41/107

(54) **GALVANIC ISOLATED PIEZOELECTRIC TRANSFORMER BASED VOLTAGE SENSORS**
SPANNUNGSSENSOREN BASIEREND AUF GALVANISCH ISOLIERTEN PIEZOELEKTRISCHEN TRANSFORMATOREN
CAPTEURS DE TENSION À BASE DE TRANSFORMATEURS PIÉZOÉLECTRIQUES GALVANIQUEMENT ISOLÉS

(30) Priority: 01.04.2014 US 201461973583 P
(43) Date of publication of application: 08.02.2017
(73) Proprietor: Qortek, Inc., Wiliamsport, Pennsylvania 17701 (US)
(72) Inventor: KNOWLES, Gareth J., Williamsport, Pennsylvania 17701 (US); BRADLEY, William M., Williamsport, Pennsylvania 17701 (US); BIRD, Ross, Williamsport, Pennsylvania 17701 (US)
(74) Representative: Lippert Stachow Patentanwälte Rechtsanwälte
(86) International application number: PCT/US2015/023930
(87) International publication number: WO 2015/153798

(56) References cited:
- WO-A1-2013/019905
- JP-A- H02 216 063
- JP-A- H10 135 529
- US-A- 5 341 061
- US-A- 5 404 064
- US-A- 6 054 796
- US-A1- 2006 087 199
- US-A1- 2006 238 070
- US-A1- 2007 086 274
- LELE S ET AL: "Piezoelectric Transformer Based Disturbance Monitoring Methodology for High-Voltage Power Supply Lines", IEEE SENSORS JOURNAL, vol. 14, no. 5, 2 January 2014 (2014-01-02), pages 1425-1434, XP011542705, ISSN: 1530-437X, DOI: 10.1109/JSEN.2013.2296504 [retrieved on 2014-03-12]

## Description

### I. TECHNICAL FIELD

The invention relates to a galvanically isolated device capable of monitoring, tracking, or transmitting voltage waveforms of either analog type or low frequency digital type.

### II. BACKGROUND ART

Applications requiring galvanic isolation include industrial sensors, medical transducers, auxiliary converters, battery chargers, choppers, and mains powered switchmode power supplies. Operator safety and signal quality are insured with isolated interconnections. Such isolated interconnection often incorporates isolation amplifiers as to provide the capability of monitoring the voltage level.

For some instruments and sensors, low-level DC and AC voltage levels must be accurately monitored even in the presence of high common-mode noise. Voltage sensors facilitate monitoring of voltage levels within an electrical system. They identify undervoltage or overvoltage concerns and their isolation capability can be used to protect other parts of the electronics that are connected to the voltage level being monitored. Such devices are commonly used to detect occurrence of any variation from nominal voltage, provide voltage tracking and data logging of performance, provide electrical isolation between two electrically connected subcircuits or components within an electrical system, identify phase-loss conditions, monitor overvoltage/undervoltage conditions as to aid in diagnosis, indicate voltage conditions that may cause stress in or damage to soft start components (SSCs). Such devices that measure AC voltage levels are used in applications such as power demand control, power failure detection, load sensing, safety switching, and motor overload control. Electrical voltage sensors that measure DC voltages are used in energy management control systems (EMCS), rail monitoring systems, building control systems (BCS), fault detection, data acquisition, and temperature control. They are also used in power measurement, analysis, and control.

It is straightforward to design non-isolated voltage amplifiers/sensors. Prior art teaches simple methods of obtaining non-isolated voltage level shifting from either AC or DC voltage to DC voltage using either voltage divider networks or capacitor divider networks (mainly for low current applications). For example, a resistor divider network can be directly coupled to the anode and cathode of the potential to be monitored. In this approach the output voltage of the appropriately selected second leg of the voltage divider is fed into an analog-to-digital converter, for example consisting of an op-amp in a voltage follower configuration that feeds into a low-pass filter. A more complex version of this is provided in Reference [1] for generalized ground loop configurations. An issue that such designs raise is that there can be serious equipment problems and/or human safety challenges when employing a non-isolated amplifier/sensor. Such concerns cause electronics designers to add an isolation stage as to ensure that equipment is electrically isolated. Providing electrical isolation eliminates ground loops, also common-mode range of data acquisition system can be increased, and it enables level shifting of the signal ground reference to a single system ground. It also enhances the ability of an electrical system to prevent high-voltage and transient voltages to be transmitted across its boundary to other, more sensitive, electronics or even a user. For example, by adding a transformer isolation coupling between the voltage signal and the resistive divider network by adding protection diodes to ground and power supply at the rail pins of the op-amp. Such isolation transformers are often designed to have insulation between primary and secondary as to withstand any occurrence of high voltage between windings.

To enable such isolated voltage monitoring/level shifting requires a more complex methodology. The existing methodology is to have a first stage that is a voltage-to-charge converter and a second stage that is a charge detector. In such isolated voltage transformers, a magnetic-coupled isolation stage such as that of Reference [2] or switched capacitor (SC) coupling circuit such as that of Reference [3] may be employed as to provide isolation voltage sensing.

There are two kinds of voltage sensors commonly used; these are either of the 'in-line' voltage sensors type or non-intrusive type. Both types of voltage sensor can be employed to measure current flow using a magnetic coupling effect. Usually such voltage sensors are based on using the Hall Effect. These sensors enable measurement of direct, alternating and impulse voltages with galvanic insulation between the primary and secondary circuits through current in a primary winding of a gapped magnetic transformer as caused by the voltage source of interest to be monitored. This, in turn, causes a magnetic flux in (the primary winding of) the magnet circuit. The gapped magnetic transformer channels this magnetic flux. A Hall Effect probe placed within this air gap provides a voltage proportional to this flux, and therefore proportional to the voltage source of interest.

Prior art such as disclosed in Reference [4] and Reference [5] describe a second method of providing an isolated voltage sensor that is obtained by employing a switched-capacitor (SC) coupling circuit. Prior art utilizes an input differential signal which is converted to a proportional charge on the capacitor by gates controlling charging and discharging of appropriate capacitors. Then the charge is detected by a differential amplifier with high input resistance. The isolation barrier is established by a configuration of capacitors and an array of gating switches. Reference [6] describes a simplified version of such a circuit.

Opto-isolators have been commonly used to isolate voltage; however, such optical devices have well-established issues with temperature causing them to degrade. There is a further issue that the measurement signals they produce can be nonlinear. A linearizing feedback can be added on the isolated side to obtain desired linear performance, but this requires an isolated power supply to operate an op amp on the output side. Opto-isolators have further problems for missile and space applications in that these devices are subject to photonic caused measurement corruption.

Another approach has been published that exploits piezoelectric effects. Piezo-optical voltage isolators have been demonstrated by hard attaching a piezoelectric device to a fiber-optic cable. In Reference [7] ABB Corporation introduced an approach for a sensing high-voltage flow wherein a Bragg grated optical fiber is mechanically fixed along the radial direction of a conventional piezoelectric disc. A wavelength shift modulation is obtained as a result of the converse piezoelectric effect as a function of applied source voltage to a pair of electrodes. A demodulation scheme is introduced for the attached fiber Bragg sensor based on source spectral characteristics as to derive the voltage waveform amplitude. This prior art is an example of inferring voltage level by the change in a fiber-optic cable property as a function of the strain induced in a piezoelectric device hard coupled to the cable and subject to a high electrical field that is to be measured. See References [8], [9], [10]. Piezo-optical voltage isolators have many serious drawbacks as voltage sensors, they rely on assurance of intimate mating of the fiber and piezoelectric devices, they require that the piezoelectric device be isolated and they can only measure voltage for the situations of high electrical field. There can be inaccuracies due to noise coupling between the high-voltage (HV) source and the electric strain gauge, and these devices rely on having pre-generated a model of the strain coupling behavior. The biggest issues are that these fiber-optic coupled voltage sensors can only measure a low frequencies and only for high voltages, rendering them not-useful for the vast majority of applications.

Reference [11] introduces a piezoelectric transformer as an isolated voltage sensor that dispenses with the need for a fiber-optic cable. As with a magnetic transformer, a piezoelectric transformer has a primary electroded capacitor and a secondary electroded capacitor that are separated by a non-electroded region. The device processes the output side electrical signal of a transformer to gain knowledge of the voltage signal to be monitored or transmitted, where this voltage signal functions as the as the driving voltage on the primary side of said transformer. Because the primary and secondary capacitors are separated by a non-electroded region the input and output signals are galvanic isolation. In fact, such ceramic isolation can be designed to have larger isolation than a comparable magnetic transformer based voltage sensor.

Reference [11] identifies that designing such piezoelectric transformer to operate as a resonance device introduces some significant drawbacks. At low frequencies, the voltage signals will not be sufficient to excite a piezoelectric transformer designed to operate at resonance, causing the transformer to be physically large (as dictated by the long wavelength). Reference [11] also identifies the drawback that, due to it having a high mechanical quality factor, a resonant piezoelectric transformer is a narrow band transformer that can only sense or transmit voltage signals in the range of frequencies close to its resonant frequency. Because resonance piezotransformers possess high frequency, such voltage sensors will be simply unable to measure low frequency and near-dc voltage signals. Reference [11] further identifies the drawback that such a resonant piezoelectric voltage sensor will require accurate gain between the primary and secondary. For these reasons, even though there are significant drawbacks, the prior ad of directly coupled piezotransformer based voltage sensors has centered on 'off-resonance' design. Further, document US 5,341,061 discloses a piezoelectric transformer circuit having a piezoelectric transformer unit with an input and first and second outputs having a common electrode terminal, wherein a first output is coupled to a drive circuit feeding the piezoelectric transformer unit for self-excited oscillation, and a second output is coupled to an output circuit. Document JPH10-135529 A discloses a piezoelectric transformer circuit having an input side circuit, a piezoelectric transformer and an output side circuit, wherein the output of the input side circuit is fed to an input side of the piezoelectric transformer, wherein a signal is taken from the input side of the piezoelectric transformer and fed back to the input side circuit, and wherein the piezoelectric transformer has an output side being coupled to the output side circuit. A similar self-oscillating piezoelectric transformer arrangement for current/voltage detection with feed-back taken from input side electrodes is known from JP H2-216063 A.

One of the problems with non-resonant piezotransformer based voltage sensors is that they demonstrate only low energetic efficiency and low gain capability. They also require a housing that applies mechanical pre-stress. Such housings can be very complex as they require a means to adjust the pre-load condition to compensate for changes in electrical load at the output. Because the transformer behavior now becomes dependent on the stiffness with the pre-stress, the housing now needs to incorporate force measurement capability. The resulting voltage sensor is only capable of low energetic efficiency and low gain capabilities, further restricting its applicability.

### III. SUMMARY OF THE INVENTION

An object of at least one embodiment of the invention is to provide a piezotransformer circuit that can monitor or transmit analog or digital voltage signal information in an isolated fashion that does not require optical, magnetic transformer or switched capacitive coupling components.

Another object of at least one embodiment of the present invention is to provide an analog piezotransformer circuit that can monitor or transmit analog or digital voltage signal information in an isolated fashion that does not require optical, magnetic transformer or switched capacitive coupling components.

An additional object of at least one embodiment of the invention is that it provides a piezotransformer circuit that can monitor or transmit analog voltage signal information in an isolated fashion over a wide bandwidth that can be as low as near dc at lower end and can in the MHz range at the upper end without requiring any additional components or supplementary power supply.

A further object of at least one embodiment of the invention is that it provides a piezotransformer circuit that can monitor or transmit digital voltage signal information in an isolated fashion at less than 2MHz bandwidth without requiring any additional components or supplementary power supply.

Yet another object of at least one embodiment of the invention is to provide an isolated piezotransformer circuit that can accurately monitor or transmit a very low power voltage signal in an isolated fashion.

Still a further object of at least one embodiment of the invention is to provide a piezotransformer circuit that can accurately monitor or transmit a voltage signal with very high galvanic isolation and negligible capacitive coupling.

Another object of at least one embodiment of the present invention is to provide isolated voltage waveform monitoring that is highly efficient without incorporating dedicated measurement, isolation or feedback circuitry.

Another object of at least one embodiment the present invention is to provide a 15 piezotransformer circuit that can operate over a very wide thermal range between low ambient temperatures that can include up to high ambient temperatures.

A further object of at least one embodiment of the present invention is at least one piezotransformer circuit embodiment of a voltage isolator, monitor or transmitter that can operate over a very wide thermal range that can include down to low ambient temperatures.

Another objective of the present invention is at least one piezotransformer circuit embodiment that provides an extremely radiation tolerant voltage isolator or isolated voltage sensor.

The present invention is embodied by a voltage sensor according to the independent claim 1. Further advantageous features are set out in the dependent claims. In at least one embodiment, a galvanically isolated voltage sensor has a mechanically integral piezoelectric transformer assembly that comprises at least first and second distinct galvanically isolated outputs and at least one input. The mechanically integral piezoelectric transformer assembly generates a modulation carrier signal having a frequency equal to a mechanical resonance frequency of the mechanically integral piezoelectric transformer assembly. A modulation circuit is provided which has a first input coupled to the first galvanically isolated output of the mechanically integral piezoelectric transformer assembly and receives the modulation carrier signal. The modulation circuit further receives a source voltage signal and modulates the source voltage signal with the modulation carrier signal to generate a modulation circuit output signal. The modulation circuit is connected to and transmits the modulation circuit output signal to at least one input of the mechanically integral piezoelectric transformer assembly, thereby forming an internal self-oscillating circuit within the piezoelectric transformer assembly. One or more demodulators are coupled to the one or more outputs of the mechanically integral piezoelectric transformer assembly, where the mechanically integral piezoelectric transformer assembly outputs a piezoelectric transformer assembly signal that is proportional to the modulated voltage source signal. Said mechanically integral piezoelectric transformer assembly includes at least first and second distinct galvanically isolated subtransformers sharing a common primary side, the first subtransformer having part of its output coupled to said modulation circuit as to supply the carrier signal from the internal self-oscillation circuit and the second subtransformer being coupled to one of said demodulators.

In one embodiment, a galvanically isolated voltage sensor has a mechanically integral piezoelectric transformer assembly that comprises at least first and second distinct galvanically isolated outputs and at least one input. A start circuit is operatively coupled with the mechanically integral piezoelectric transformer assembly to initiate transformer operation. The mechanically integral piezoelectric transformer assembly generates a modulation carrier signal having a frequency equal to a mechanical resonance frequency of the mechanically integral piezoelectric transformer assembly. A modulation circuit is provided which has a first input coupled to the first galvanically isolated output of the mechanically integral piezoelectric transformer assembly and receives the modulation carrier signal. The modulation circuit further receives a source voltage signal and modulates the source voltage signal with the modulation carrier signal to generate a modulation circuit output signal. The modulation circuit is connected to and transmits the modulation circuit output signal to at least one input of the mechanically integral piezoelectric transformer assembly, thereby forming an internal self-oscillating circuit within the piezoelectric transformer assembly. One or more demodulators are coupled to the one or more outputs of the mechanically integral piezoelectric transformer assembly, where the mechanically integral piezoelectric transformer assembly outputs a piezoelectric transformer assembly signal that is proportional to the modulated voltage source signal. Said mechanically integral piezoelectric transformer assembly includes at least first and second distinct galvanically isolated subtransformers sharing a common primary side, the first subtransformer having part of its output coupled to said modulation circuit as to supply the carrier signal from the internal self-oscillation circuit and the second subtransformer being coupled to one of said demodulators.

In still another embodiment of the invention, a voltage sensor includes a mechanically integral piezoelectric transformer assembly having at least first and second distinct galvanically isolated outputs and at least one input. The mechanically integral piezoelectric transformer assembly generates a modulation carrier signal that has a frequency equal to a mechanical resonance frequency of the mechanically integral piezoelectric transformer assembly. A linear boost circuit is provided that receives a source voltage signal and amplifies source voltage signal. A start circuit is operatively coupled to the mechanically integral piezoelectric transformer assembly to initiate transformer operation. A modulation circuit which has a first input coupled to the first galvanically isolated output of the mechanically integral piezoelectric transformer assembly and receives the modulation carrier signal. The modulation circuit receives the amplified source voltage signal from the linear boost circuit and modulates the amplified source voltage signal with the modulation carrier signal to generate a modulation circuit output signal. The modulation circuit is connected to and transmits the modulation circuit output signal to at least one input of the mechanically integral piezoelectric transformer assembly, thereby forming an internal self-oscillating circuit within the piezoelectric transformer assembly. One or more demodulators are coupled to the one or more outputs of the mechanically integral piezoelectric transformer assembly which outputs a piezoelectric transformer assembly signal that is proportional to the modulated voltage source signal. Said mechanically integral piezoelectric transformer assembly includes at least first and second distinct galvanically isolated subtransformers sharing a common primary side, the first subtransformer having part of its output coupled to said modulation circuit as to supply the carrier signal from the internal self-oscillation circuit and the second subtransformer being coupled to one of said demodulators.

### IV. BRIEF DESCRIPTION OF THE DRAWINGS

FIG. 1 shows an isolated voltage sensor in accordance with an embodiment of the invention.
FIG. 2A illustrates an isolated voltage sensor in accordance with an embodiment of the invention that employs a piezoelectric subtransformer.
FIG. 2B depicts an isolated voltage sensor in accordance with an embodiment of the invention that employs a piezoelectric subtransformer.
FIG. 3 shows a further embodiment of the isolated voltage sensor of the invention where the isolated voltage sensor includes a start circuit.
FIG. 4 illustrates a further embodiment of the isolated voltage sensor of the invention depicting components of the modulation circuit.
FIG. 5 depicts yet another embodiment of the isolated voltage sensor of the invention.
FIG.6 illustrates a further embodiment of the isolated voltage sensor of the invention.
FIG. 7A shows still another embodiment of the isolated voltage sensor of the invention.
FIG. 7B illustrates an additional embodiment of the isolated voltage sensor of the invention.
FIG. 8 depicts another embodiment of the isolated voltage sensor of the invention.
FIG. 9 illustrates yet a further embodiment of the isolated voltage sensor of the invention.
FIG. 10 depicts another embodiment of the isolated voltage sensor of the invention.
FIG. 11 shows still another embodiment of the isolated voltage sensor of the invention.
FIG. 12 shows a further embodiment of the isolated voltage sensor of the invention.
FIG. 13 illustrates another embodiment of the isolated voltage sensor of the invention.
FIG. 14 depicts another embodiment of the isolated voltage sensor of the invention.
FIG. 15 illustrates an example of a start circuit used in several embodiments of the isolated voltage sensor of the invention.
FIG. 16 depicts an example of a demodulator used in several embodiments of the isolated voltage sensor of the invention.
FIG. 17 illustrates an example of a piezoelectric transformer assembly used in several embodiments of the isolated voltage sensor of the invention.
FIG. 18 another example of a piezoelectric transformer assembly used in several embodiments of the isolated voltage sensor of the invention.
FIG. 19 shows another example of a piezoelectric transformer assembly used in several embodiments of the isolated voltage sensor of the invention.

### V DESCRIPTION OF THE EMBODIMENTS OF THE INVENTION

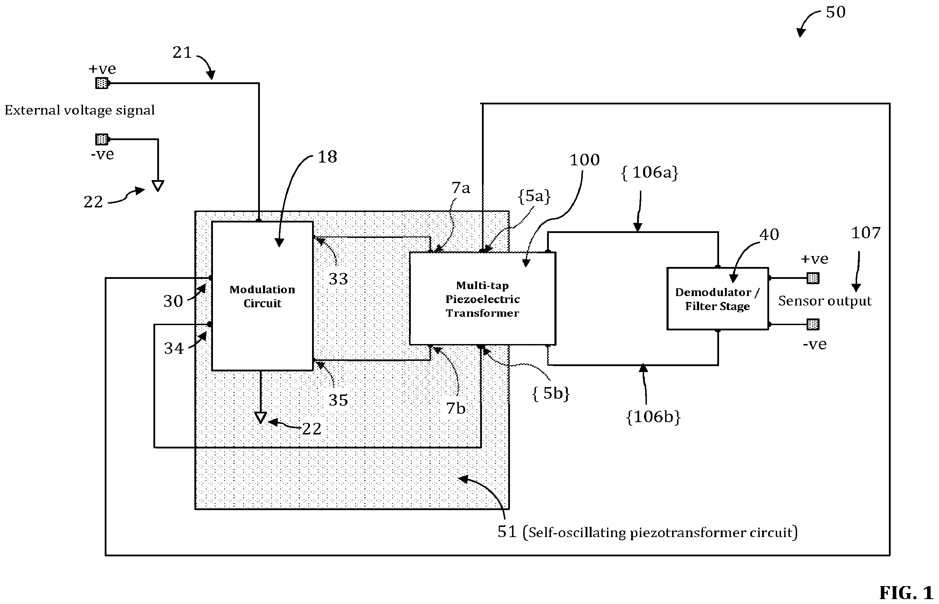

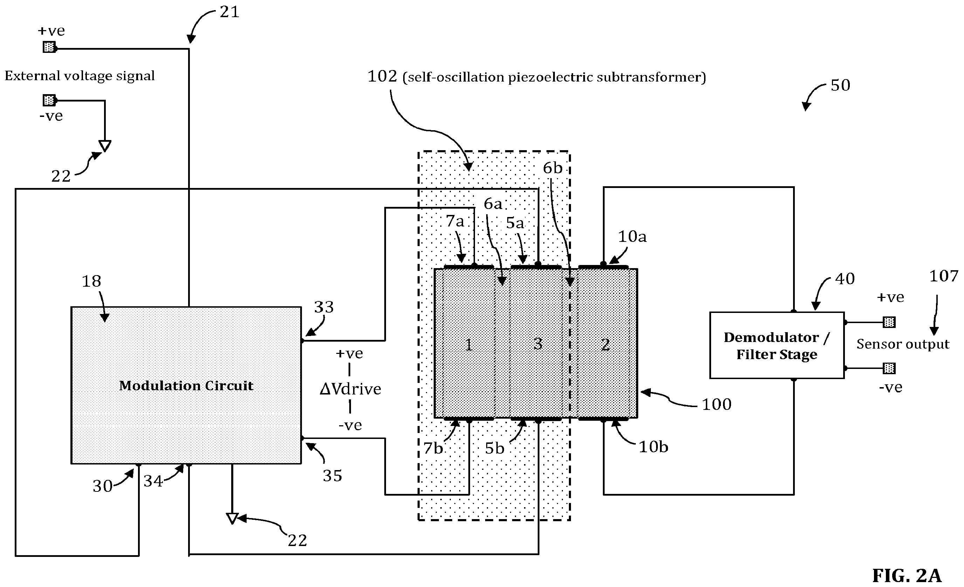

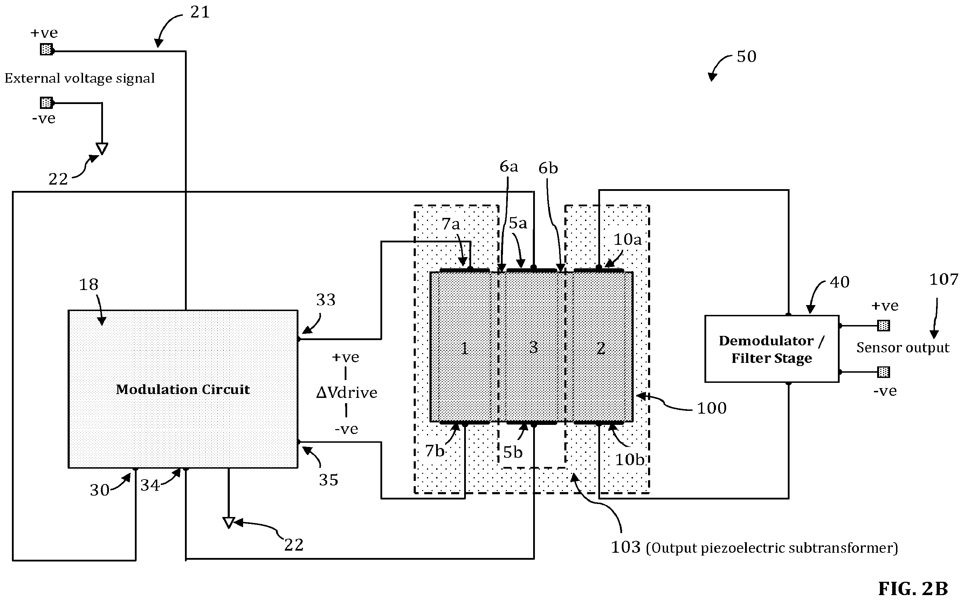

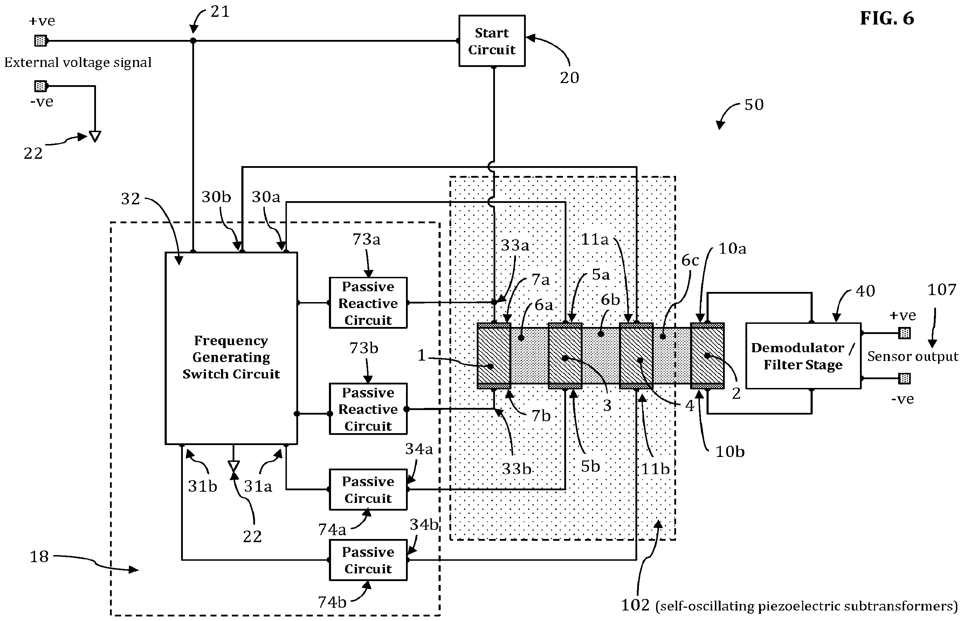

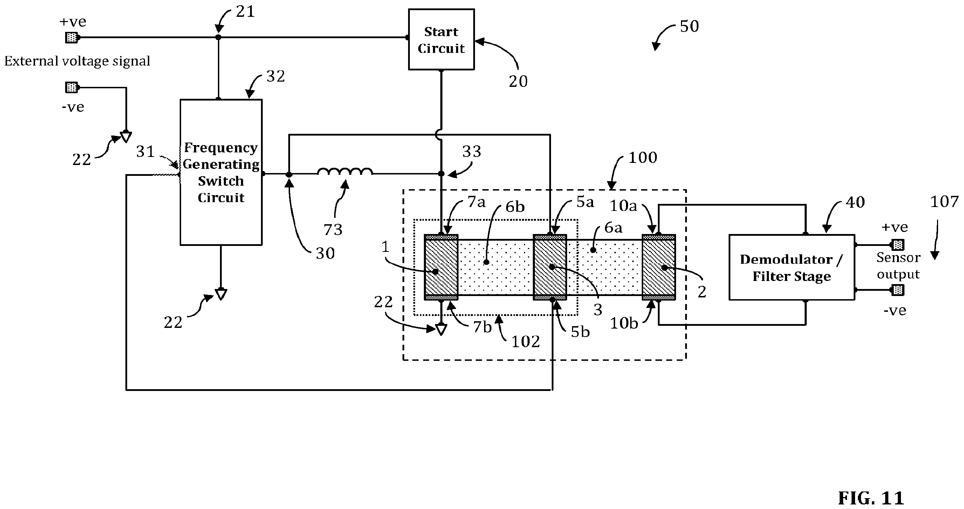

The present invention is for a voltage sensor **50** that utilizes an internal self-oscillating piezoelectric transformer circuit to modulate an external voltage signal that is to be monitored or transmitted in a galvanic isolated fashion. Referring to FIG. 2A, the piezoelectric piezoelectric transformer assembly 100 is a single mechanically integral device that incorporates two or more distinct galvanic isolated subtransformers that all share a common input side **1** that acts as a common primary side. Referring to FIG. 2A, region **102** of piezoelectric piezoelectric transformer assembly 100 forms such a subtransformer. The galvanic isolated signal transmitted is demodulated on the secondary side of one or more of the subtransformers, normally referred to as the output subtransformers. Referring to FIG. 2B, region **103** of piezoelectric piezoelectric transformer assembly 100 forms such a subtransformer. Referring to FIG. 2 and FIG. 6, one or more of these subtransformers is an integral part of the internal self-oscillating piezoelectric transformer circuit. The subtransformers of said internal self-oscillating piezoelectric transformer circuit being distinct from the output subtransformers. The inverse effect exhibited by all piezoelectric materials causes the secondary sides of all of the subtransformers of piezoelectric transformer assembly 100 to produce a sinusoidal response at a common resonant frequency that is the resonant frequency of the mechanically integral piezoelectric transformer assembly 100. This common sinusoidal frequency must always be the resonant frequency of the piezoelectric transformer assembly 100 independent of how it varies with temperature, loading, or pressure. Referring to FIG. 1, this common resonant frequency is used by the modulation circuit **18** to modulate the external voltage signal **21**. According to Shannon's theory the external voltage signal 21 can be accurately reconstructed provided its bandwidth is less than 1/20^{th} of the modulation frequency. Referring to FIG. 11, the self-oscillating modulator circuit **18**, as to include the self-oscillating subtransformers, can be implemented using wideband gap switches as to provide a modulation bandwidth in low GHz, therefore the invention can implement isolated voltage sensing dictated solely by the mechanical resonance of piezoelectric transformer assembly 100, which can be in the MHz range.

FIG. 1 illustrates an embodiment of the voltage sensor **50** that first modulates an external voltage signal 21 and then uses the modulated signal as the electrical excitation signal **33** of the common input side of multiple distinct and mutually isolated piezoelectric subtransformers of piezoelectric transformer assembly **100**. One or more of these subtransformers has its output electrodes **10a** and **10b** connected to a demodulation and filter stage 40. One or more of the self-oscillation subtransformers within piezoelectric transformer assembly 100 has its output electrodes **5a** and **5b** connected to modulation circuit **18** as to form part of a self-oscillation circuit. In this embodiment, none of the electrodes **10a, 10b, 5a,** and **5b** are connected to common ground **22**. The modulation circuit **18** acts to modulate the external voltage **21** using a galvanic isolated sinusoidal signal generated at the secondary taps of the self-oscillation subtransformers. As noted, this sinusoidal signal is at the mechanical frequency of piezoelectric transformer assembly 100 irrespective of which subtransformer is used as the self-oscillation subtransformers. By modulating this sinusoidal signal by the voltage signal 21 the resulting modulated signal of high side **33** and low side **35,** also having the mechanical resonance of **100,** are connected to the electrodes **7a** and **7b** respectively of the common primary side of all of the subtransformers. Typically the modulation output signal low side **35** is connected to common ground **22,** but this may not be the case in certain embodiments. Because it is at mechanical resonance, the power applied to the common primary side of all of the output subtransformers has near-maximum power transfer to the secondary sides of said subtransformers. The design of the piezoelectric transformer assembly 100, including materials selection, electrode geometry and placement will determine a fixed transmission gain between the modulation signal **33** with reference to **35** and output potentials at electrode **10a** in reference to those at electrode **10b.** The transmitted modulation signal with gain then acts as input into a demodulation and filter stage 40. The demodulation and filter stage output voltage signal **107** is a replica of the external voltage signal **21** subject to a fixed gain that is galvanically isolated from the input voltage signal **21.**

FIG 2A together with FIG 2B provides an embodiment of FIG. 1 wherein transformer assembly 100 includes a self-oscillation subtransformer **102** and an output subtransformer **103.** In this embodiment the common input (primary) side of the subtransformers is a capacitor 1 manufactured of piezoelectric material with electrical (electroded) terminals **7a** and **7b,** this acts as the common primary side for all of the subtransformers of piezoelectric transformer assembly 100. The secondary side of the output subtransformer **103** is a capacitor **2** manufactured of piezoelectric material with electrical (electroded) terminals **10a** and **10b.** The secondary side of the self-oscillation subtransformer **102** is a capacitor **3** manufactured of piezoelectric material with electrical (electroded) terminals **5a** and **5b.** Although certain configurations and poling schemes can lead to requiring **7a** and **5a** to have the same polarity, under normal circumstances these should have opposite polarity forcing **7b** and **5b** to similarly have opposite polarity. One selection of polarity of **10a** and **10b** will maintain the polarity of the external voltage signal **21**, and the other selection will invert the polarity of the external voltage signal **21**. In the embodiments discussed herein, transformer assembly is comprised of ceramic materials. However, the skilled artisan will realize that the transformer assembly may be comprised of other piezoelectric materials.

Electrodes **5a** and **5b** are connected to inputs **30** and **34** of modulation circuit **18.** Because the voltage inputs are taken from the secondary side of a piezotransformer they must necessarily be of frequency corresponding to whichever mechanical modal frequency of piezoelectric transformer assembly 100 is being primarily excited by drive signal **7a** with reference to **7b**. The arrangement of piezotransformer assembly **100** is that its mechanical resonance frequency is significantly greater than the bandwidth of the source voltage signal 21. This causes the high side output voltage signal **5a** of the self-oscillation subtransformer **102** with reference to its low side signal **5b** to be a sinusoid of frequency significantly greater than the bandwidth of the source voltage signal **21** referred to herein as the modulation carrier signal. As an edifying example, the source voltage waveform **21** with reference to **22** may have a maximum bandwidth of 400Hz and the properties of piezoelectric transformer assembly **100** are so selected to have a first mechanical resonant frequency of 100KHz. In some embodiments, the modulation circuit **18** is a 3-input port circuit with ground **22** common to the ground of external voltage signal **21** to be galvanic isolated tracked or transmitted. The pair of signals **5a** and **5b** are now of sufficient frequency as to be used as a modulation carrier signal for external voltage signal **21**. The modulation circuit **18** is a 2-output port circuit and the potential difference voltage of these outputs **33** and **35** are connected to the positive and negative terminals of the common input **1** of piezoelectric transformer assembly 100. Because the frequency of the voltage waveform output voltage ΔVdrive = **33** - **35** (referred to herein as the modulation circuit output signal) at the common input **1** of modulation circuit **18** is determined by the modulation carrier frequency ΔVmodulate = **5a** - **5b**, which, by the laws of physics, has to be precisely at the mechanical frequency of piezoelectric transformer assembly 100, the drive frequency of capacitor **1** is always identical to the mechanical frequency of piezoelectric transformer assembly 100 independent of time, temperature, pressure, or loading conditions. Therefore, the modulation circuit acts to modulate the external voltage **21** with a carrier signal that is suitably high that is completely determined by the mechanical behavior of piezoelectric transformer assembly 100 and is at the mechanical resonance of piezoelectric transformer assembly **100.** By the laws of physics, this sinusoidal modulated signal (modulation circuit output signal) appearing across the electrodes **7a** and **7b** of the output piezotransformer is recreated across the electrodes **10a** and **10b** at the secondary side of the output subtransformer **103** subject to the output transformer gain. A standard demodulator 40, typically with added filter, will recreate the external voltage signal **21**, subject to the same output subtransformer gain.

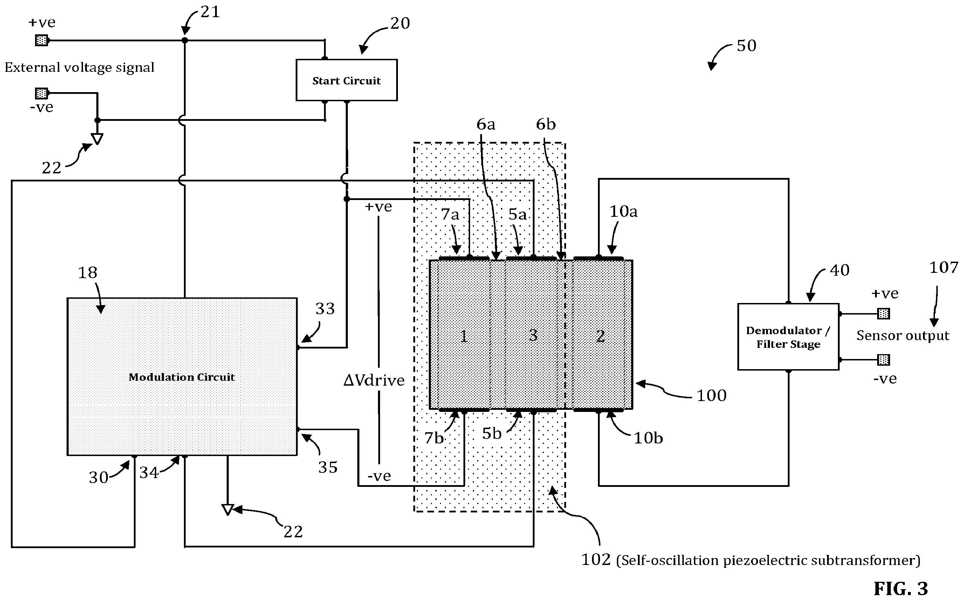

In certain situations, typically when tracking very low strength voltage signals, the signal source **21** may not be sufficient to initiate the modulation process and cannot be relied upon to start-up the voltage sensor **50**. FIG. 3 provides a method that ensures that the isolated voltage sensor is operating. A start circuit **20** is added that takes its power from the voltage source signal **21** to be monitored. The start circuit output connects to the positive electrode termination **7a** of common input **1**, as to induce an initial non-zero potential ΔVdrive across common input **1.** For multilayer configurations of piezoelectric transformer **100**, where **7a** includes a set of electrodes with common reference **7b** the output of the start circuit **20** need only be connected to one such electrode. The voltage produced by the start circuit can alternatively be connected to electrode **5a** or electrode **10a,** as to initiate the operation of isolated voltage sensor device **50**. The start circuit **20** provides sufficient energy into the piezoelectric transformer assembly 100 as to cause a sinusoidal voltage waveform ΔVmodulate = **5a** - **5b** be sufficient as to cause a potential ΔVdrive across common input **1**. A specific mechanical mode i.e. resonant frequency for operation of device **50** may be selected by simply ensuring that the drive signal output waveform of **20** has a frequency that is reasonably close to that selected resonance as to not couple with a nearby resonance mode. For most applications of device **50** the selected frequency will be the fundamental frequency; however a higher mode may be selected for the purpose of developing a higher frequency sinusoidal modulation input into modulation circuit **18** for applications such as isolated transmission of a digital signal source **21.**

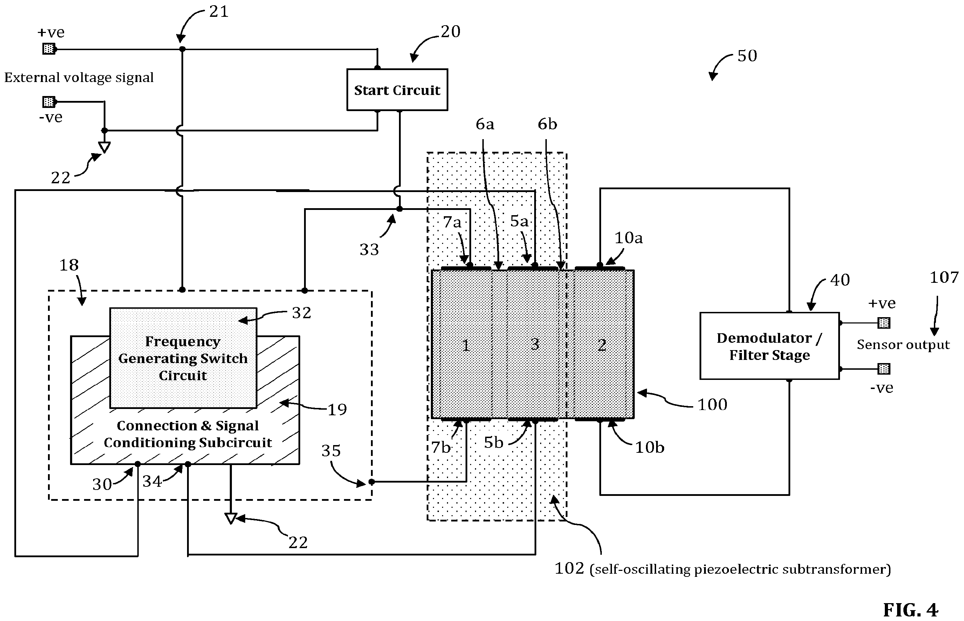

In accordance with an embodiment of the present invention described in FIG. 4, the modulation circuit **18** may be comprised of two interconnected subcircuits: a frequency generating switch subcircuit **32** and a connection and signal conditioning subcircuit **19.** The external voltage signal **21** to be monitored or tracked in an isolated fashion is connected to frequency generating subcircuit **32** and shares common ground **22.** Signal conditioning subcircuit **19** conditions the sinusoidal signal ΔVmodulate that enters at ports **30** and **34,** the resulting conditioned signal being at the same frequency as ΔVmodulate. The resulting conditioned signal is then injected as a drive carrier signal into the frequency generating switch circuit **32** with reference to ground **22.** The output of the frequency generating switch circuit **32** is further conditioned by another part of connection and signal conditioning subcircuit **19** before being connected to the terminals **7a** and **7b** of the common input **1.**

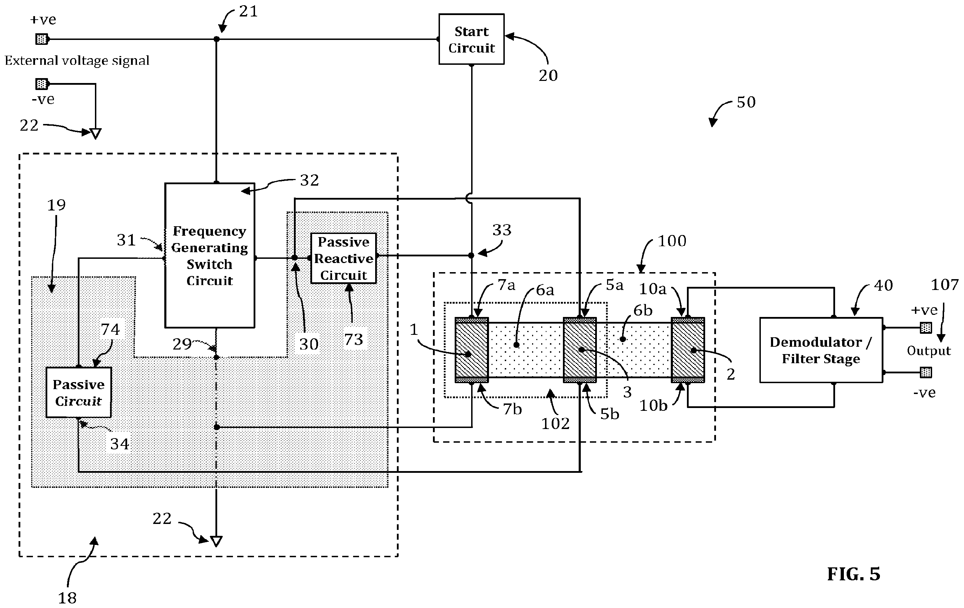

FIG. 5 is an embodiment of device of FIG. 4 wherein the connection & signal conditioning subcircuit **19** has a first part consisting of a passive circuit **74** with input port **34** connected to **5b,** and a second part **73** with input port **30** connected to both **7a** and the non-ground output of the frequency generating switch subcircuit **32.** By this arrangement the passive circuit **74** provides a high frequency injection signal into the frequency generating switch subcircuit **32** at its input port **31** at exactly the mechanical resonance frequency of piezoelectric transformer assembly 100. The start circuit **20** is configured so that subsequent to startup of device 50 the voltage contribution of start circuit **20,** as seen at node **33,** becomes redundant and can therefore be removed. Examples of circuits that are suitable to function as a start circuit **20** and that will automatically shut down once the self-sustaining internal source follower becomes active are further described below.

FIG. 6 is an embodiment of the device of FIG. 4 wherein the connection and signal conditioning subcircuit **19** has a first part consisting of passive circuits **74a** and **74b** disposed between terminal **5b** and terminal **11b**, respectively, and input ports **31b** and **31a,** respectively, of the frequency generating switch subcircuit **32.** By this arrangement the passive circuit **19** provides a high frequency injection signal into the frequency generating switch subcircuit **32** at input ports **31a** and **31b** both having a sinusoidal frequency at the mechanical resonance frequency of piezoelectric transformer assembly 100. The connection and signal conditioning subcircuit **19** has a second part consisting of passive circuits **73a** and **73b** disposed between input port **30a** and **30b** and the high side **7a** and the low side **7b** of the common primary side **1.** As with previous circuits and figures, this is presented in its simplest form for expository purpose, as it is commensurate with the simplest embodiment of the frequency generating switch circuit **32** that consists of a switching full-bridge circuit. The start circuit **20** is configured so that subsequent to start-up of device **50** the voltage contribution of start circuit **20,** as seen at node **33a,** becomes redundant and can therefore be removed. Examples of circuits that are suitable to function as a start circuit **20** and that will automatically shut down once the self-sustaining internal source follower becomes active are further described below.

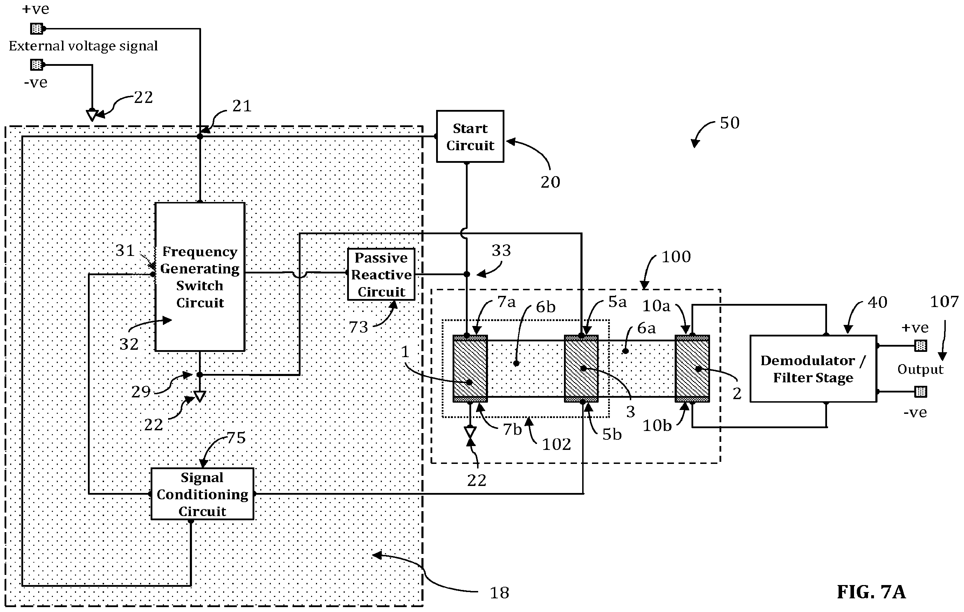

FIG. 7A provides an embodiment of the invention described in FIG. 5 with the following distinctions: (i) a signal conditioning circuit **75,** replacing the passive circuit **74,** is interposed between the input port **31** of frequency generating switch circuit **32** and the low-side output **5b** of the self-oscillating subtransformer **102**; (ii) the high-side output **5a** of self-oscillating subtransformer **102** is connected to common ground **22.** In this configuration the electron flow loop 22, 5a, 5b, 31, 33, 7a, 7b, 22 forms a closed self-resonant subcircuit that resonates at a mechanical resonance frequency of piezoelectric transformer assembly 100 where this resonance selection is determined by the start circuit **20** or will default to the fundamental first resonance of piezoelectric transformer assembly 100 in the absence of such a start circuit **20.** The signal conditioning circuit **75** derives its power from the voltage source signal **22.**

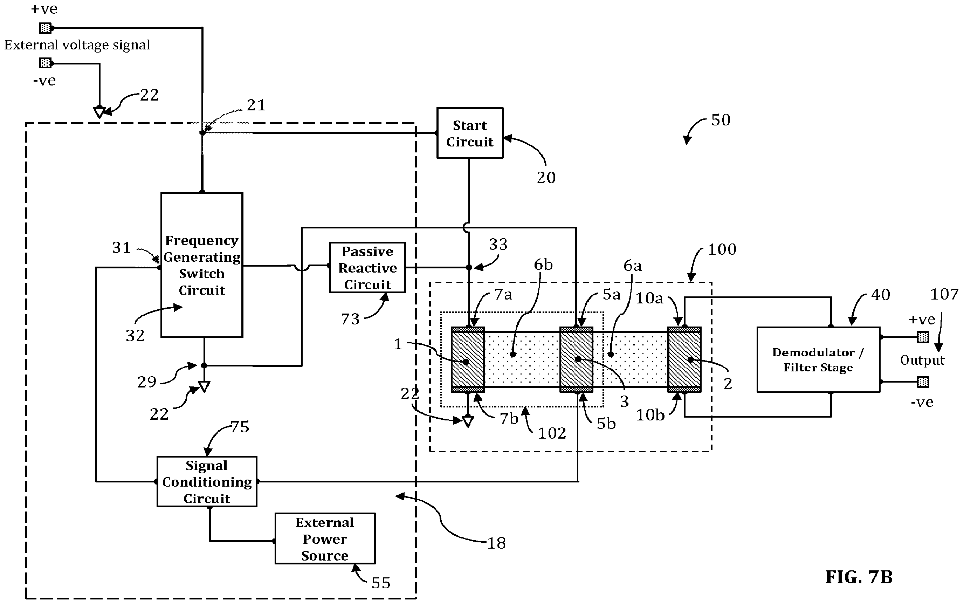

FIG. 7B provides an embodiment of the invention described by FIG. 5 that is identical to that described in FIG. 7A with the exception being that an external power source **55** is now used to supply power to the signal conditioning circuit **75.**

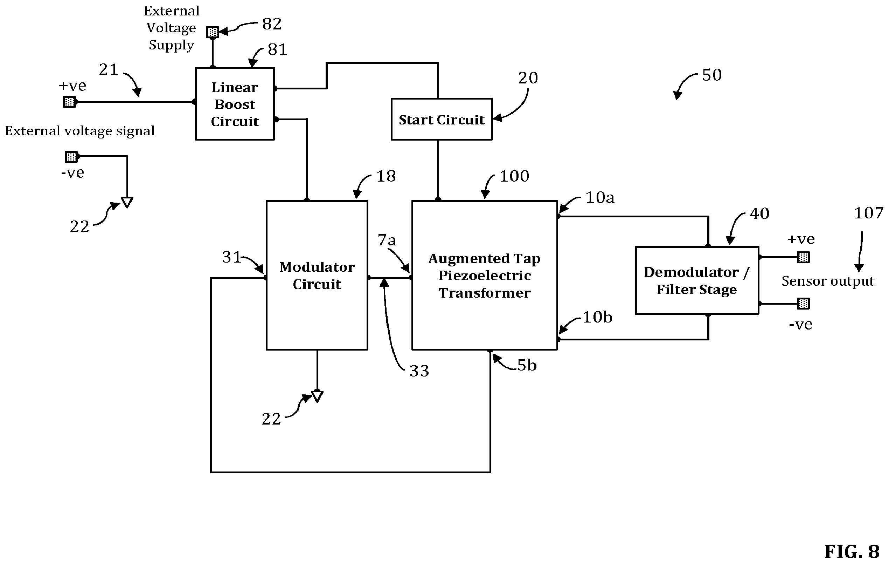

FIG. 8 provides a modification of FIG. 1 designed for situations where the signal strength of the source voltage waveform **21** is too low to initiate or maintain the operation of device **50.** This embodiment is identical to that described by FIG. 1 with the distinction that a linear boost circuit **81** is interposed between the source voltage signal **21** and the modulation circuit **18.** The linear boost circuit derives its power from an external voltage source **82.** The start circuit **20** may also be boosted by the linear boost circuit **81.**

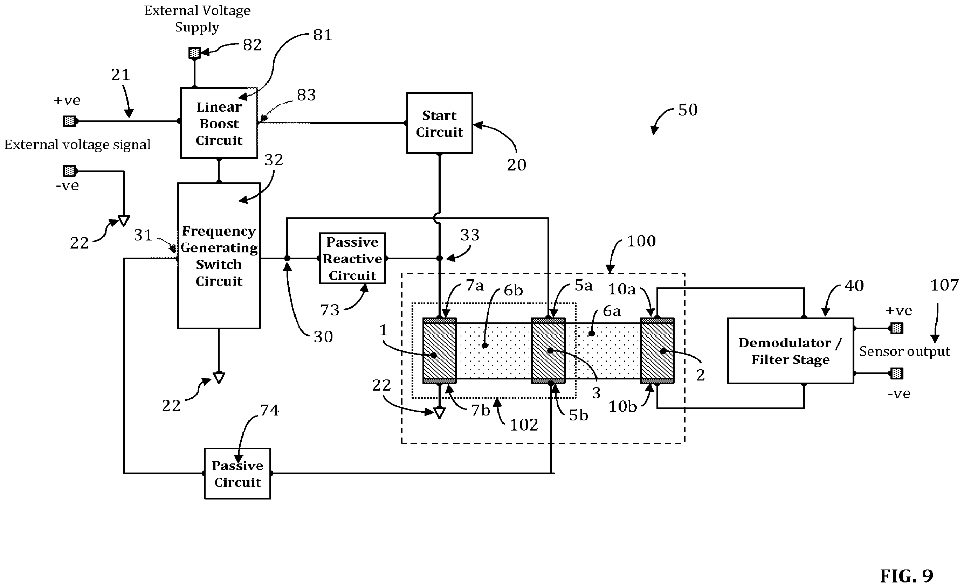

**FIG. 9** provides for an embodiment of the invention that is applicable to the monitoring of small or very small signal voltage waveforms where the source voltage **21** may be insufficient to enable the start circuit **20** to correctly function as to enable electron flow in the switch circuit **31.** The start circuit **20** is boosted by an additional amplification pre-stage such as linear boost circuit **81** which is powered by an external voltage source **82.** The output at node **83** of linear boost circuit **81** would be selected as to provide sufficient energy as to enable the start circuit **20** to electrically excite the common subtransformers input **1** as to produce sufficient power at the output **5b** of the self-oscillation subtransformer **102**. The linear boost circuit **81** may also continue to boost the external voltage signal input **21** as to assist in continuing to supply sufficient current as to maintain self-drive operation as described in FIG. 5.

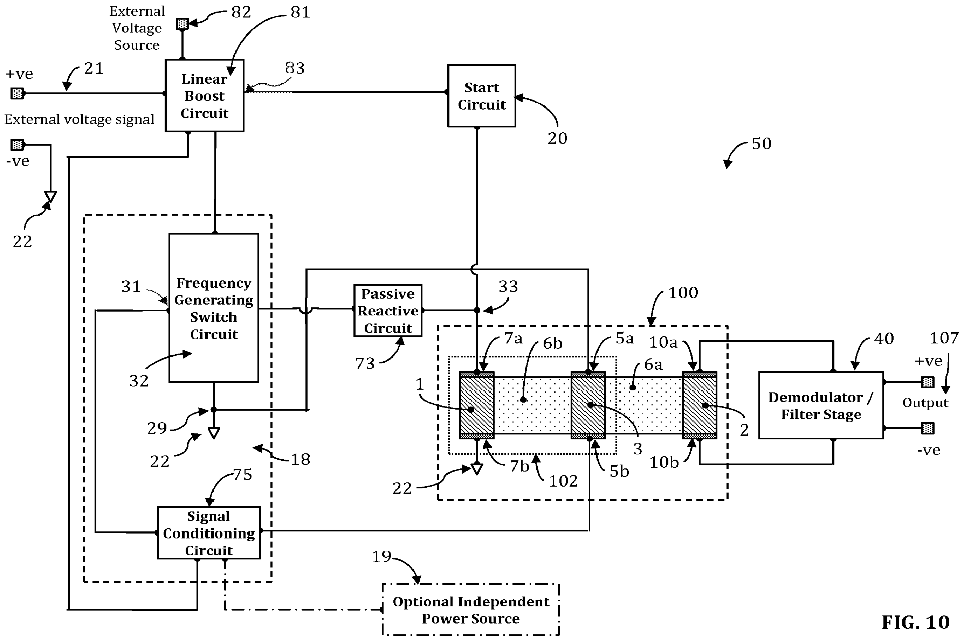

FIG. 10 provides for an embodiment of the invention that is applicable to monitoring small, or very small, signal voltage waveforms where the external voltage signal **21** may be insufficient to enable the start circuit **20** to cause the self-oscillation subcircuitry of **50** to initiate. The start circuit **20** is now boosted by an additional amplification pre-stage **81** supplied by an external voltage source **82.** The output port **83** of **81** now provides sufficiently strong power characteristics as to enable the self-oscillation subcircuitry of **50** to initiate. The linear boost circuit **81** may be employed also continue to boost the sensor input **21** as to assist in continuing to supply sufficient current as to maintain proper operation of the self-oscillation subcircuitry. The signal conditioning circuit **75** may either derive its power from the amplification pre-stage **81** or may derive its power from an independent power source **19,** such as a battery or super capacitor.

FIG. 11 provides an embodiment of the galvanic isolated voltage sensor **50** as described in FIG. **5****.** In this embodiment the passive circuit **74** consists of a short circuit and the passive reactive circuit **73** consists of an inductor. This embodiment is conducive to half-bridge implementations of the frequency generating switch circuit **32.** A similar second embodiment of the galvanic isolated voltage sensor **50** can be obtained by making the same second subcircuit selections for the passive circuit devices **74a** and **74b** and passive reactive circuit **73a** and **73b** as described in FIG. 6. Such an embodiment will be conducive to full-bridge implementations of the frequency generating switch circuit **32.**

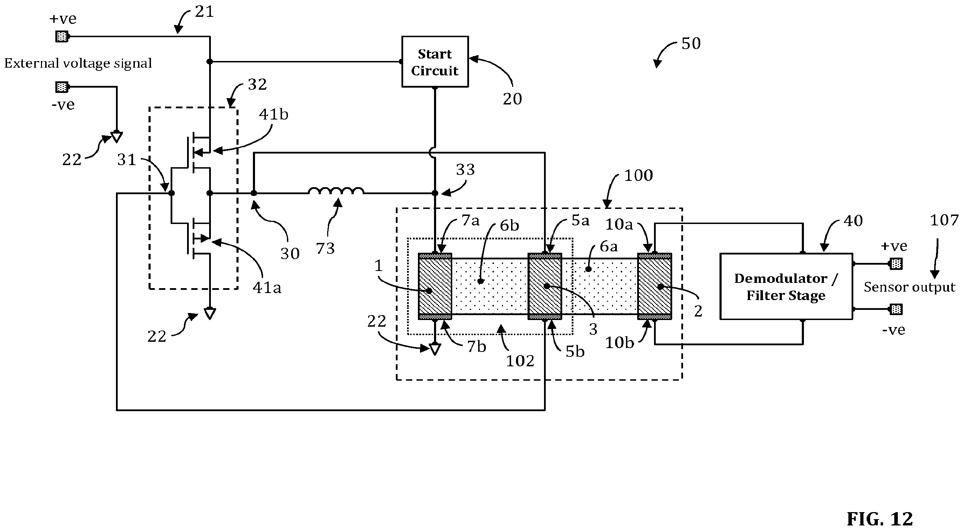

FIG. 12 provides a low part count embodiment of the galvanic isolated voltage sensor 50 as described in FIG. 1. In this embodiment the passive circuit **74** consists of a short circuit and the passive reactive circuit **73** consists of an inductor. In this embodiment the frequency generating switch circuit 32 is a half-bridge transistor circuit consisting of an n-channel MOSFET device 41b and a p-channel MOSFET device 41b. Its input power is the external voltage signal input **21,** its gate drive is provided by connecting the low-side output **5b** of the secondary side **3** of the self-oscillating subtransformer **102** to the gate at port **31,** and its output is connected to inductor **73** that is interposed between the high-side output **5a** of the secondary side of the of the self-oscillating subtransformer **102** and the high-side **7a** of the common primary side **1.** Other selections of transistor devices will provide alternate embodiments.

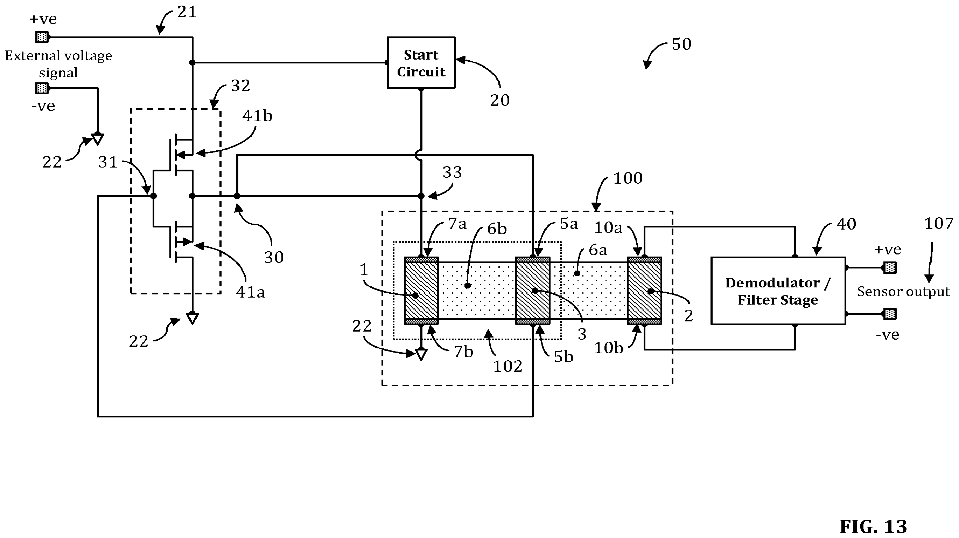

FIG. 13 provides a low part count embodiment of the galvanic isolated voltage sensor 50 identical to FIG. 12 except that the passive reactive circuit **73** now consists of a short circuit the drive carrier wave excitation of the common input side of the subtransformers is now the (voltage source signal) modulated square wave pulse train waveform at node 56 produced by the power half-bridge. Due to potential crack initiation of the ceramic due to driving the input (primary) side of the subtransformers with a square wave pulse train this embodiment should only be employed for short duration or low duty cycle applications.

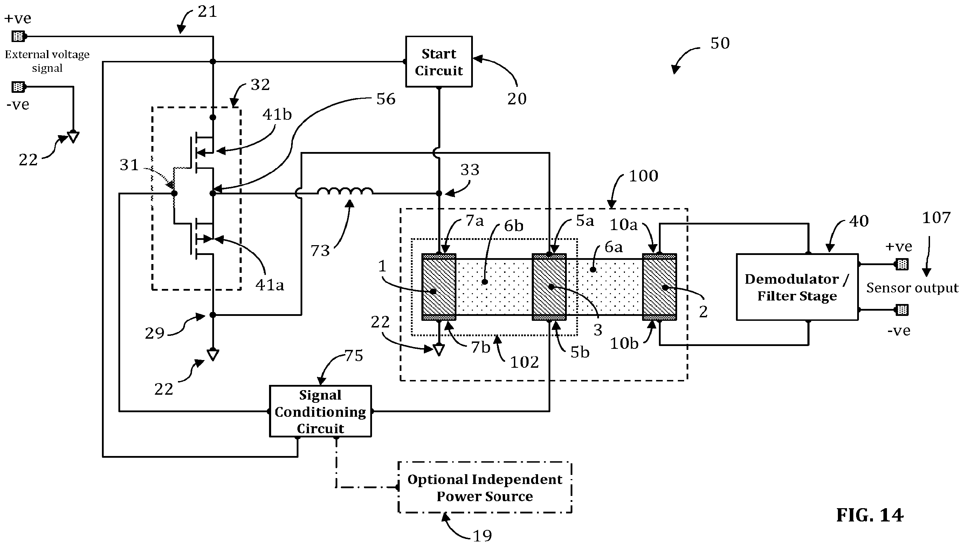

FIG. 14 provides a low part count embodiment of the galvanic isolated voltage sensor 50 that functions similar to that described by FIG. 11 and FIG. 12 with the following distinctions: (i) An active signal conditioning circuit **75** that replaces the short circuit **74** is interposed between the low-side electrical terminal **5b** of the self-oscillating subtransformer and the gate signal port 31 of a transistor half-bridge **32;** (ii) The high-side terminal **5a** of the self-oscillating subtransformer is connected to the common ground **22.** The active signal conditioning circuit **75** may derive its power from the voltage signal source **21,** linear boost circuit **81** (not shown), or an independent power source **19,** such as a battery or super capacitor. . A second low part count full-bridge embodiment of the galvanic isolated voltage sensor **50** can be obtained by making the similar connections to a signal conditioning circuit **75** that now replaces **74a** and **74b of** FIG. 6, and a full-bridge implementation of the frequency generating switch circuit **32** as described in FIG. 6.

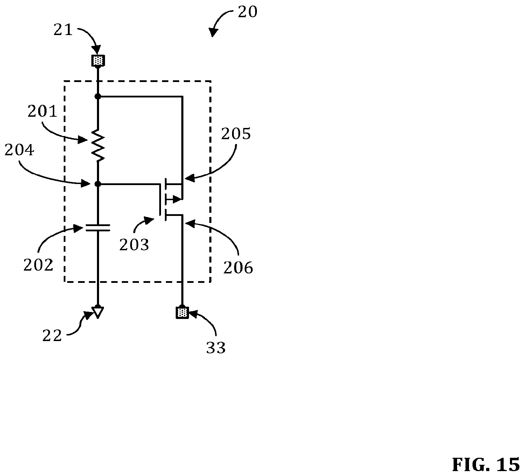

FIG. 15 provides an example of start circuit **20** of FIG. 3 that is of a low part count. For this embodiment a MOSFET **203** is selected as either a depletion n-channel or depletion p-channel. MOSFET **203** has source terminal **205** is connected to the external voltage signal at node **21** and its drain terminal **206** is connected to node **33.** The gate terminal **204** of **203** is terminated at the connection between the two components of a series RC circuit formed by resistor **201** and capacitor **202** that is itself disposed between the high-side voltage of the external signal **21** and common ground **22.** Depletion-mode MOSFET devices are doped so that a channel exists even with zero voltage V_{GS} between gate terminal **204** and source terminal **206.** To control the channel, a negative voltage is applied to the gate for an n-channel device, depleting the channel, which pinches off the electron flow through the device. Similarly a positive voltage is applied to the gate for a p-channel device. Upon start up there is no charge flow between voltage signal **21** and ground **22** and therefore the MOSFET device is closed enabling charge to flow from Vcc directly into node **33** connected to the first terminal **7a** of section 1 of the transformer subcircuit **102.** This causes a pulse voltage waveform at the high-side terminal **7a** of the secondary of the self-oscillating subtransformer referenced to common ground **22.** Because the transformer subcircuit **102** is comprised of piezoelectric materials the waveform **33** must cause a non-zero sinusoidal voltage waveform at the output side of the transformer **102.** The power of this waveform being entirely dependent on the supply, where the supply is signal **21** i.e. Vcc = Vsignal (**21**) or, if insufficient, provided by an external power source **82.** As determined by the RC time constant of the start circuit, Vg increases the voltage at the gate of the device. Correctly selected RC components will provide sufficient positive voltage as cause the depletion MOSFET device to become open as to prevent any further current flow through node **33,** apart from very small subthreshold leakage, between Vcc and node **33.**

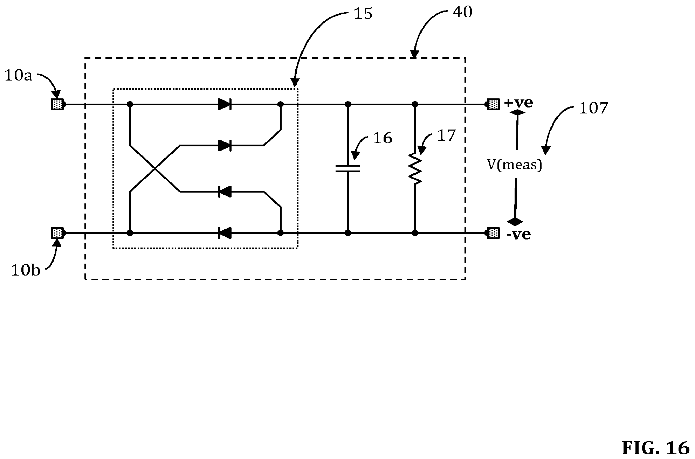

FIG. 16 provides an example of a suitable demodulation and filter circuit 40 of the invention FIG. 1. The embodiment provides a passive component solution to implementing of the demodulation/filter of the invention with a minimal number of components. The demodulation/filter embodiment employs such a full wave diode rectifier and RC filter. In this embodiment first terminal **10a** and second terminal **10b** are connected at nodal inputs to a two-wire input of a full-wave diode bridge **15** whose two wire outputs are connected across a parallel RC circuit formed by capacitor **16** and resistor **17.** The negative terminal **10b** is floating, and not connected to common ground **22,** as to ensure high galvanic isolation of the voltage sensor. The effective bandwidth of the voltage sensor is determined by selection of components **16** and **17.** The resulting isolated copy of the original external voltage signal **21** is given by V (meas) **107.** The accuracy of **107** in duplicating **21,** subject to the gain of the transformer, requires that the capacitance should be selected as to not damp the measurement waveform signal; moreover, the resulting RC constant should ensure minimal attenuation below its cutoff frequency (= 1/RC). An obvious modification requiring the same minimal number of components would employ an RC divider network connected to the output of the full wave rectifier **15.** Other demodulation/filter subcircuit embodiments of prior art can be employed for demodulation/filter of the output ac signal of piezoelectric transformer assembly 100; for example, incorporating an active low pass filter design as to introduce additional signal gain and stopband characteristics.

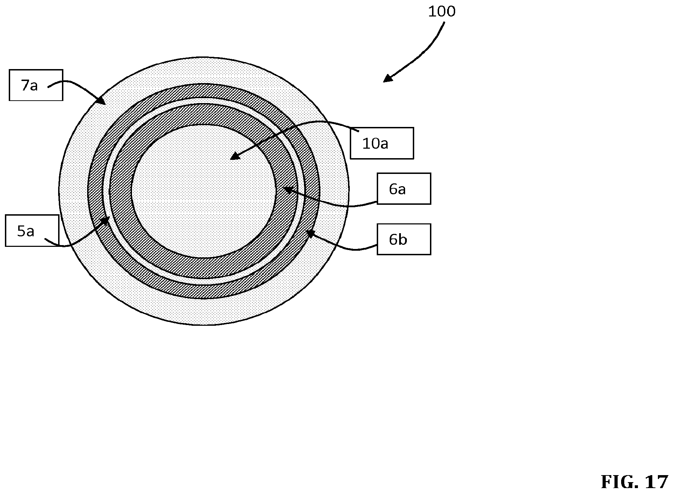

FIG. 17 provides a top view flat planar embodiment of piezoelectric transformer assembly 100 that consists of concentric rings that alternate between electroded regions and non-electroded regions. The piezoelectric transformer assembly 100 is symmetrically electroded so that the underside is identical to its topside (shown). Its planar shape shown as a disc can also have annular, square, oval or other planar geometry, each featuring a similar series of nested regions that are alternately electroded and non electroded.

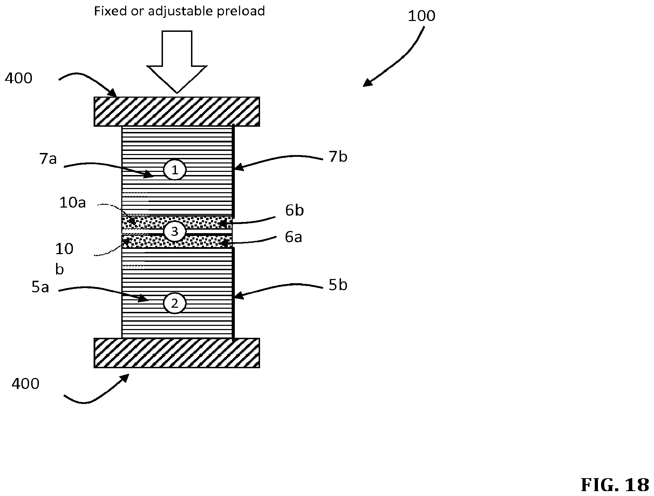

FIG. 18 provides an embodiment of piezoelectric transformer assembly 100 that consists of two piezoelectric devices **1** and **2,** which are either monolithic or multilayer, separated by a third piezoelectric **3** by non-conductive layers **6a** and **6b.** The piezoelectric devices and non-conductive layers sharing near identical planar footprint are captured in a housing **400** that induces a fixed or a variable preload on the captured piezoelectrics **1,2** and **3.**

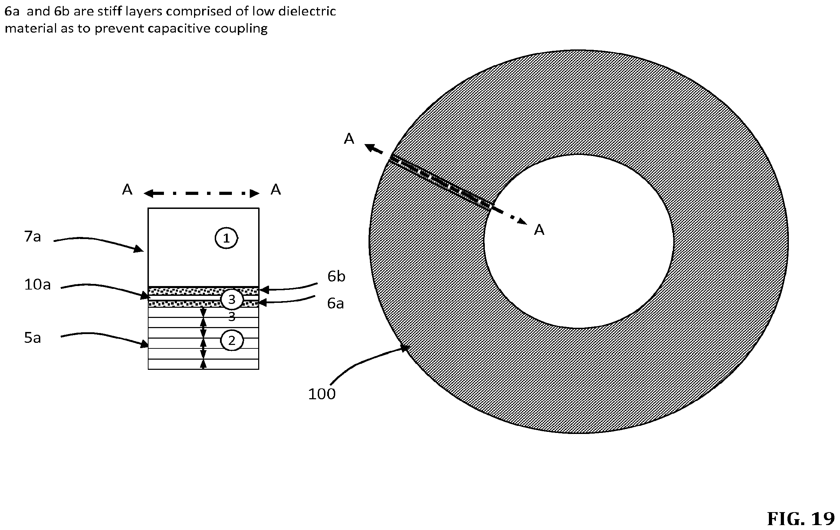

FIG. 19 provides an embodiment of piezoelectric transformer assembly 100 that consists of a thick circular washer whose cross section is shown in cut **A-A.** The common input 1 consists of a single monolithic piezoelectric, the output **2** consists of a multilayer piezoelectric, and the self-oscillation device 3 consists of a single layer piezoelectric **3** separated from **1** and **2** by non-conductive rings **6a** and **6b.** The piezoelectric devices and non-conductive layers sharing near identical planar footprint.

The device and its embodiments shown in FIG. 1 to FIG. 19 may further incorporate one or more additional galvanic isolated self-oscillation electroded subtransformers, as exampled in FIG. 6, as to provide a separate reference signal to another device or circuit. The device and its embodiments shown in FIG. 1 to FIG. 19 may further incorporate one or more additional galvanic isolated output subtransformers as to provide multiple reference signals or control signals to multiple devices.

The device and its embodiments shown in FIG. 1 to FIG. 19 may have a frequency generating switch circuit comprised of low power transistor (emitter-gain-collector topology) devices for small signal (low power) voltage measurement and/or tracking whereas MOSFET (source-gate-drain topology) devices might normally be employed for high power voltage measurement and/or tracking. Alternate frequency generator circuits **32** might be used, such as a super source follower circuit to enhance the low input voltage linearity, or other configured circuit architecture that provides increased stability. Modifications of the subcircuits might be used when employing low power transistor devices to monitor and/or track a small signal voltage. With obvious modifications of the self-drive subcircuit of FIG. 2A/2B and its embodiments, monitoring of DC voltage fluctuation, as opposed to AC voltage measurement, can be accomplished using just a single transistor switch device.

The accompanying drawings illustrate embodiment and prototype examples of the invention. Based on this disclosure, one of ordinary skill in the art will appreciate that the use of "same", "identical" and other similar words are inclusive of differences that would arise during manufacturing to reflect typical tolerances for goods of this type.

As used above "substantially," "generally," and other words of degree are relative modifiers intended to indicate permissible variation from the characteristic so modified. It is not intended to be limited to the absolute value or characteristic which it modifies but rather possessing more of the physical or functional characteristic than its opposite, and preferably, approaching or approximating such a physical or functional characteristic. "Substantially" also is used to reflect the existence of manufacturing tolerances that exist for manufacturing components.

It should be noted that the present invention may, however, be embodied in many different forms and should not be construed as limited to the embodiments and prototype examples set forth herein; rather, the embodiments set forth herein are provided so that the disclosure will be thorough and complete, and will fully convey the scope of the invention to those skilled in the art. The accompanying drawings illustrate embodiment and prototype examples of the invention. Based on this disclosure, one of ordinary skill in the art will appreciate that the use of "same", "identical" and other similar words are inclusive of differences that would arise during manufacturing to reflect typical tolerances for goods of this type.

### REFERENCES

[1] Parag V. Acharya and Fred H. Boettner, US Patent US 20130027238 A1, (2013)
[2] Paul Horowitz and Winfield Hill, "The Art of Electronics 2nd Ed.," (1989)
[3] Xueuing Qui, US Patent number 5,361,037 (1994)
[4] Josef Nossek, US Patent number 4,354,169 (1982)
[5] Xueuing Qui, US Patent number 5,361,037 (1993)
[6] Pentti Mannonen, US Patent number 6,549,056 (2003)
[7] M Pacheco, F. Mendoza Santoyo, A Mendez and L A Zenteno, "Piezoelectric-modulated optical fibre Bragg grating high-voltage sensor," Measurement Science and Technology Volume 10, Number 9 (1999)
[8] K Kawamura et al, Development of a high voltage sensor using a piezoelectric transducer and a strain gage,' IEEE Trans. Instrum. Meas. 37 564-8
[9] M Pacheco et al, Piezoelectric-modulated optical fibre Bragg grating high-voltage sensor,' Meas. Science and Technology 09/1999; 10:777-782
[10] M Mozafari et al, 'Design and fabrication of piezo-optical Fabry-Perot voltage sensor,' Avionics, Fiber-Optics and Photonics Technology Conference, 2008
[11] A Carazo, "Novel Piezoelectric Transducers for High Voltage Measurements,' Ph.D. Thesis, Universitat Politecnica De Catalunya, 2000
[12] Svetlana Bronstein and Sam Ben-Yaakov, "Design Considerations for Achieving ZVS in a Half Bridge Inverter that Drives a Piezoelectric Transformer with No Series Inductor," DOl:10.1109/PSEC.2002.1022516 In proceeding of: Power Electronics Specialists Conference, 2002. pesc 02. 2002 IEEE 33rd Annual, Volume 2, (2012)

## Claims

1. A voltage sensor (50) comprising:
a mechanically integral piezoelectric transformer assembly (100) having at least first and second outputs and at least one input, said mechanically integral piezoelectric transformer assembly (100) generating a modulation carrier signal having a frequency equal to a mechanical resonance frequency of said mechanically integral piezoelectric transformer assembly (100); a modulation circuit (18) having a first input coupled to the first output of said mechanically integral piezoelectric transformer assembly (100) and receiving a modulation carrier signal, said modulation circuit (18) receiving a source voltage signal (21) and modulating the source voltage signal (21) with the modulation carrier signal as to generate a modulation circuit output signal, said modulation circuit (18) being connected to and transmitting the modulation circuit output signal to the at least one input of said mechanically integral piezoelectric transformer assembly (100), thereby forming an internal self-oscillating circuit including said modulation circuit (18) and said piezoelectric transformer assembly (100); one or more demodulators (40) coupled to the second output of said mechanically integral piezoelectric transformer assembly (100), wherein said mechanically integral piezoelectric transformer assembly (100) outputs a piezoelectric transformer assembly signal that is proportional to the carrier modulated voltage source signal,
**characterized in that**
said first and second outputs are distinct galvanically isolated outputs, wherein said mechanically integral piezoelectric transformer assembly (100) includes at least first and second distinct galvanically isolated subtransformers (102, 103) sharing a common primary side (1), the first subtransformer (102) having its output coupled to said modulation circuit (18) as to supply the carrier signal for the internal self-oscillation circuit, and the second subtransformer (103) being coupled to one of said demodulators (40).

2. The voltage sensor (50) of claim 1, wherein the common primary side (1) of said mechanically integral piezoelectric transformer assembly (100) includes a capacitive section provided with first and second electrodes (7a, 7b) coupled to an output of said modulation circuit (18), the secondary side (2) of the second subtransformer (103) includes a capacitive section having first and second electrodes (10a, 10b) coupled to an input of said demodulator (40), and the secondary side (3) of the first subtransformer (102) includes a capacitive section having first and second electrodes (5a, 5b) coupled to an input of said modulation circuit (18).

3. The voltage sensor (50) of claim 1, further comprising a start circuit (20) operatively coupled to said mechanically integral piezoelectric transformer assembly (100) to initiate transformer operation.

4. The voltage sensor (50) of claim 3, wherein said start circuit (20) is connected to said primary side, the first subtransformer (102) is coupled to said modulation circuit (18), and the second subtransformer (103) is coupled to one of said demodulators (40).

5. The voltage sensor (50) of claim 4, wherein the common primary side includes a capacitive section provided with first and second electrodes (7a, 7b) coupled to an output of said modulation circuit (18), a secondary side of the second subtransformer includes a capacitive section having first and second electrodes (10a, 10b) coupled to an input of said demodulator (40), and a secondary side of the first subtransformer includes a capacitive section having first and second electrodes (5a, 5b) coupled to the first input of said modulation circuit (18).

6. The voltage sensor (50) of claim 5, wherein said modulation circuit (18) includes a frequency generating switch subcircuit (32) that receives the source voltage signal (21), and a connection and signal conditioning subcircuit (75) that receives the modulation carrier signal.

7. The voltage sensor (50) of claim 5, wherein said modulation circuit (18) includes: a frequency generating switch subcircuit (32) that receives the source voltage signal (21); a passive circuit (74) having an input coupled to the secondary side of the first subtransformer and an output connected to one or more inputs of the frequency generating switch circuit (21); and a passive reactive circuit (73) having an input connected to an output of the frequency generating switch circuit (32) and to the common primary side of said piezoelectric transformer assembly (100).

8. The voltage sensor (50) of claim 7, wherein the passive circuit (74) is a short circuit and the passive reactive circuit (73) is an inductor.

9. The voltage sensor (50) of claim 8, wherein the frequency generating switch circuit (32) includes a half bridge circuit.

10. The voltage sensor (50) of claim 7, wherein the passive reactive circuit (73) is a short circuit, the passive reactive circuit (73) is a short circuit, and the frequency generating switch subcircuit (32) includes a half bridge circuit.

11. The voltage sensor (50) of claim 3, wherein said modulation circuit (18) includes:
a frequency generating switch subcircuit (32) that receives the source voltage signal (21); a signal conditioning circuit (75) having an input coupled to a first part of the first galvanically isolated output with as second part of the first galvanically isolated output connected to ground and an output connected to an input of the frequency generating switch circuit (32); and a passive reactive circuit (73) having an input connected to an output of the frequency generating switch circuit (32) and having an output coupled to the common primary side.

12. The voltage sensor (50) of claim 11, wherein the signal conditioning circuit (75) is powered by one of the source voltage signal (21) and an external power source (55).

13. The voltage sensor (50) of claim 11, wherein the passive reactive circuit (73) is an inductor and the frequency generating switch subcircuit (32) includes a half bridge circuit.

14. The voltage sensor of claim : 3, further comprising a linear boost circuit (81) that receives and amplifies the source voltage signal (21).

15. The voltage sensor (50) of claim 14, wherein the common primary side includes a capacitive section provided with first and second electrodes (7a, 7b), the secondary side of the second subtransformer includes a capacitive section having first and second electrodes (10a, 10b) coupled to an input of said demodulator (40), and a secondary side of the first subtransformer includes a capacitive section having first and second electrodes (5a, 5b) connected to said modulation circuit (18).

16. The voltage sensor (50) of claim 15, wherein said modulation circuit (18) includes: a frequency generating switch subcircuit (32) that receives the amplified source voltage signal; a passive circuit (74) having an input coupled to the one of the first and second electrodes (5a, 5b) of the secondary side of the first subtransformer and an output connected to an input of the frequency generating switch circuit (32); and a passive reactive circuit (73) having an input connected to an output of the frequency generating switch circuit (32) and one of the first and second electrodes of the secondary side of the first transformer (5a, 5b) and having an output connected to one of the first and second electrodes (7a, 7b) of the common primary side.

17. The voltage sensor (50) of claim 14, wherein said modulation circuit (18) includes: a frequency generating switch subcircuit (32) that receives the amplified source voltage signal; a signal conditioning circuit (75) having an input coupled to one of the first and second electrodes (5a, 5b) of the secondary side of the first subtransformer and an output connected to an input of the frequency generating switch circuit (32); and a passive reactive circuit (73) having an input connected to an output of the frequency generating switch circuit (32) and an output connected to an input terminal (7a, 7b) of the common primary side where the other input of the common primary side is connected to ground.

18. The voltage sensor (50) of claim 17, wherein the signal conditioning circuit (75) is powered by one of the source voltage signal (21) and an external power source (55).

19. The voltage sensor (50) of claim 3, wherein said start circuit (20) includes means for automatically shutting off once transformer operation is initiated.

20. The voltage sensor (50) of claim 3, wherein said start circuit (20) automatically turns on as to initiate the self-oscillating circuit and automatically shuts off once transformer operation is initiated.

## Patentansprüche

1. Spannungssensor (50), umfassend:
eine mechanisch integrale piezoelektrische Transformatoranordnung (100) mit wenigstens einem ersten und einem zweiten Ausgang und wenigstens einem Eingang, wobei die mechanisch integrale piezoelektrische Transformatoranordnung (100) ein Modulationsträgersignal erzeugt, dessen Frequenz gleich einer mechanischen Resonanzfrequenz der mechanisch integralen piezoelektrischen Transformatoranordnung (100) ist; eine Modulationsschaltung (18), die einen ersten Eingang hat, der mit dem ersten Ausgang der mechanisch integralen piezoelektrischen Transformatoranordnung (100) verbunden ist und ein Modulationsträgersignal empfängt, wobei die Modulationsschaltung (18) ein Quellenspannungssignal (21) empfängt und das Quellenspannungssignal (21) mit dem Modulationsträgersignal moduliert, um ein Modulationsschaltungs-Ausgangssignal zu erzeugen, wobei die Modulationsschaltung (18) mit dem wenigstens einen Eingang der mechanisch integralen piezoelektrischen Transformatoranordnung (100) verbunden ist und das Modulationsschaltungs-Ausgangssignal zu diesem überträgt, wodurch ein interner selbstoszillierender Kreis gebildet wird, der die Modulationsschaltung (18) und die piezoelektrische Transformatoranordnung (100) enthält; einen oder mehrere Demodulatoren (40), die mit dem zweiten Ausgang der mechanisch integralen piezoelektrischen Transformatoranordnung (100) verbunden ist, wobei die mechanisch integrale piezoelektrische Transformatoranordnung (100) ein Signal der piezoelektrischen Transformatoranordnung ausgibt, das proportional zu dem trägermodulierten Spannungsquellensignal ist,
**dadurch gekennzeichnet, dass**
der erste und der zweite Ausgang unterschiedliche galvanisch getrennte Ausgänge sind, wobei die mechanisch integrale piezoelektrische Transformatoranordnung (100) wenigstens einen ersten und einen zweiten unterschiedlichen galvanisch getrennten Nebentransformator (102, 103) mit einer gemeinsamen Primärseite (1) aufweist, wobei der Ausgang des ersten Nebentransformators (102) mit der Modulationsschaltung (18) verbunden ist, um das Trägersignal für denen internen selbstoszillierenden Kreis zu liefern, und
wobei der zweite Nebentransformator (103) mit einem der Demodulatoren (40) verbunden ist.

2. Spannungssensor (50) nach Anspruch 1, wobei die gemeinsame Primärseite (1) der mechanisch integralen piezoelektrischen Transformatoranordnung (100) einen kapazitiven Abschnitt aufweist, der mit einer ersten und einer zweiten Elektrode (7a, 7b) versehen ist, die mit dem Ausgang der Modulationsschaltung (18) verbunden sind, wobei die Sekundärseite (2) des zweiten Nebentransformators (103) einen kapazitiven Abschnitt mit einer ersten und einer zweiten Elektrode (10a, 10b) aufweist, die mit einem Eingang des Demodulators (40) verbunden sind, und wobei die Sekundärseite (3) des ersten Nebentransformators (102) einen kapazitiven Abschnitt mit einer ersten und einer zweiten Elektrode (5a, 5b) aufweist, die mit dem Eingang der Modulationsschaltung (18) verbunden sind.

3. Spannungssensor (50) nach Anspruch 1, ferner umfassend eine Startschaltung (20), die zum Initiieren des Transformatorbetriebs mit der mechanisch integralen piezoelektrischen Transformatoranordnung (100) wirkverbunden ist.

4. Spannungssensor (50) nach Anspruch 3, wobei die Startschaltung (20) mit der Primärseite, der erste Nebentransformator (102) mit der Modulationsschaltung (18) und der zweite Nebentransformator (103) mit einem der Demodulatoren (40) verbunden ist.

5. Spannungssensor (50) nach Anspruch 4, wobei die gemeinsame Primärseite einen kapazitiven Abschnitt aufweist, der mit einer ersten und einer zweiten Elektrode (7a, 7b) versehen ist, die mit einem Ausgang der Modulationsschaltung (18) verbunden sind, wobei eine Sekundärseite des zweiten Nebentransformators einen kapazitiven Abschnitt mit einer ersten und einer zweiten Elektrode (10a, 10b) aufweist, die mit einem Eingang des Demodulators (40) verbunden sind, und wobei eine Sekundärseite des ersten Nebentransformators einen kapazitiven Abschnitt mit einer ersten und einer zweiten Elektrode (5a, 5b) aufweist, die mit dem ersten Eingang der Modulationsschaltung (18) verbunden sind.

6. Spannungssensor (50) nach Anspruch 5,
wobei die Modulationsschaltung (18) eine Frequenzgeneratorschalter-Teilschaltung (32) umfasst, die das Quellenspannungssignal (21) empfängt, und eine Verbindungs- und Signalaufbereitungs-Teilschaltung (75), die das Modulationsträgersignal empfängt.

7. Spannungssensor (50) nach Anspruch 5, wobei die Modulationsschaltung (18) umfasst: eine Frequenzgeneratorschalter-Teilschaltung (32), die das Quellenspannungssignal (21) empfängt; eine passive Schaltung (74), mit einem Eingang, der mit der Sekundärseite des ersten Nebentransformators verbunden ist, und mit einem Ausgang, der mit einem oder mehreren Eingängen der Frequenzgeneratorschalterschaltung (21) verbunden ist; und eine passive Reaktanzschaltung (73) mit einem Eingang, der mit einem Ausgang der Frequenzgeneratorschalterschaltung (32) und mit der gemeinsamen Primärseite der piezoelektrischen Transformatoranordnung (100) verbunden ist.

8. Spannungssensor (50) nach Anspruch 7, wobei die passive Schaltung (74) ein Kurzschluss und die passive Reaktanzschaltung (73) eine Induktivität ist.

9. Spannungssensor (50) nach Anspruch 8, wobei die Frequenzgeneratorschalterschaltung (32) eine Halbbrückenschaltung umfasst.

10. Spannungssensor (50) nach Anspruch 7, wobei die passive Reaktanzschaltung (73) ein Kurzschluss ist, die passive Reaktanzschaltung ein Kurzschluss ist und die Frequenzgeneratorschalter-Teilschaltung (32) eine Halbbrückenschaltung umfasst.

11. Spannungssensor (50) nach Anspruch 3, wobei die Modulationsschaltung (18) umfasst: eine Frequenzgeneratorschalter-Teilschaltung (32), die das Quellenspannungssignal (21) empfängt; eine Signalaufbereitungsschaltung (75) mit einem Eingang, der mit einem ersten Teil des ersten galvanisch getrennten Ausgang verbunden ist, wobei ein zweiter Teil des ersten galvanisch getrennten Ausgangs mit der Erde und ein Ausgang mit einem Eingang der Frequenzgeneratorschalterschaltung (32) verbunden ist; und eine passive Reaktanzschaltung (73) mit einem Eingang, der mit einem Ausgang der Frequenzgeneratorschalterschaltung (32) verbunden ist, und mit einem Ausgang, der mit der gemeinsamen Primärseite verbunden ist.

12. Spannungssensor (50) nach Anspruch 11, wobei die Signalaufbereitungsschaltung (75) mit dem Quellenspannungssignal (21) oder von einer externen Stromquelle (55) gespeist wird.

13. Spannungssensor (50) nach Anspruch 11, wobei die passive Reaktanzschaltung (73) eine Induktivität ist und die Frequenzgeneratorschalter-Teilschaltung (32) eine Halbbrückenschaltung umfasst.

14. Spannungssensor (50) nach Anspruch 3, ferner umfassend eine lineare Boost-Schaltung (81), die das Quellenspannungssignal (21) empfängt und verstärkt.

15. Spannungssensor (50) nach Anspruch 14, wobei die gemeinsame Primärseite einen kapazitiven Abschnitt aufweist, der mit einer ersten und einer zweiten Elektrode (7a, 7b) versehen ist, wobei die Sekundärseite des zweiten Nebentransformators einen kapazitiven Abschnitt mit einer ersten und einer zweiten Elektrode (10a, 10b) aufweist, die mit einem Eingang des Demodulators (40) verbunden sind, und wobei eine Sekundärseite des ersten Nebentransformators einen kapazitiven Abschnitt mit einer ersten und einer zweiten Elektrode (5a, 5b) aufweist, die mit der Modulationsschaltung (18) verbunden sind.

16. Spannungssensor (50) nach Anspruch 15, wobei die Modulationsschaltung (18) umfasst: eine Frequenzgeneratorschalter-Teilschaltung (32), die das verstärkte Quellenspannungssignal empfängt; eine passive Schaltung (74) mit einem Eingang, der mit einer von erster und zweiter Elektrode (5a, 5b) der Sekundärseite des ersten Nebentransformators verbunden ist, und mit einem Ausgang, der mit einem Eingang der Frequenzgeneratorschalterschaltung (32) verbunden ist; und eine passive Reaktanzschaltung (73) mit einem Eingang, der mit einem Ausgang der Frequenzgeneratorschalterschaltung (32) und mit einer von erster und zweiter Elektrode (5a, 5b) der Sekundärseite des ersten Transformators verbunden ist, und mit einem Ausgang, der mit einer von erster und zweiter Elektrode (7a, 7b) der gemeinsamen Primärseite verbunden ist.

17. Spannungssensor (50) nach Anspruch 14, wobei die Modulationsschaltung (18) umfasst: eine Frequenzgeneratorschalter-Teilschaltung (32), die das verstärkte Quellenspannungssignal empfängt; eine Signalaufbereitungsschaltung (75) mit einem Eingang, der mit einer von erster und zweiter Elektrode (5a, 5b) der Sekundärseite des ersten Nebentransformators verbunden ist, und mit einem Ausgang, der mit einem Eingang der Frequenzgeneratorschalterschaltung (32) verbunden ist; und eine passive Reaktanzschaltung (73) mit einem Eingang, der mit einem Ausgang der Frequenzgeneratorschalterschaltung (32) verbunden ist, und mit einem Ausgang, der mit einem Eingangsanschluss (7a, 7b) der gemeinsamen Primärseite verbunden ist, wobei der anderen Eingang der gemeinsamen Primärseite mit der Erde verbunden ist.

18. Spannungssensor (50) nach Anspruch 17, wobei die Signalaufbereitungsschaltung (75) mit einem Quellenspannungssignal (21) oder von einer externen Stromquelle (55) gespeist wird.

19. Spannungssensor (50) nach Anspruch 3, wobei die Startschaltung (20) Mittel umfasst zur automatischen Abschaltung, sobald der Transformatorbetrieb initiiert wird.

20. Spannungssensor (50) nach Anspruch 3, wobei die Startschaltung (20) automatisch anschaltet, um den selbstoszillierenden Kreis zu initiieren, und automatisch abschaltet, sobald der Transformatorbetrieb initiiert wird.

## Revendications

1. Capteur de tension (50) comprenant:
un dispositif de transformateur piézoélectrique mécaniquement intégré (100) ayant au moins une première et une deuxième sortie et au moins une entrée, dans lequel le dispositif de transformateur piézoélectrique mécaniquement intégré (100) génère un signal porteur de modulation dont la fréquence est égale à une fréquence de résonance mécanique du dispositif de transformateur piézoélectrique mécaniquement intégré (100); un circuit de modulation (18) ayant une première entrée couplée à ladite première sortie dudit dispositif de transformateur piézoélectrique mécaniquement intégré (100) et recevant un signal porteur de modulation, ledit circuit de modulation (18) recevant un signal de tension de source (21) et modulant ledit signal de tension de source (21) avec ledit signal porteur de modulation pour produire un signal de sortie du circuit de modulation, dans lequel ledit circuit de modulation (18) est connecté à ladite au moins une entrée dudit dispositif de transformateur piézoélectrique mécaniquement intégré (100) et transmet ledit signal de sortie du circuit de modulation à celui-ci, formant ainsi un circuit auto-oscillant interne comprenant ledit circuit de modulation (18) et ledit dispositif de transformateur piézoélectrique (100); un ou plusieurs démodulateurs (40) connectés à la deuxième sortie dudit dispositif de transformateur piézoélectrique mécaniquement intégré (100), dans lequel ledit dispositif de transformateur piézoélectrique mécaniquement intégré (100) délivre un signal du dispositif de transformateur piézoélectrique qui est proportionnel au signal de source de tension modulé par la porteuse,
**caractérisé en ce que**
les première et deuxième sorties sont des sorties différentes isolées galvaniquement, le dispositif de transformateur piézoélectrique mécaniquement intégré (100) comprenant au moins un premier et un deuxième sous-transformateur différent isolés galvaniquement (102, 103) ayant un côté primaire commun (1), dans lequel la sortie du premier sous-transformateur (102) est connectée au circuit de modulation (18) pour fournir le signal porteur pour les circuits auto-oscillants internes, et dans lequel le second sous-transformateur (103) est connecté à l'un des démodulateurs (40).

2. Capteur de tension (50) selon la revendication 1, dans lequel le côté primaire commun (1) du dispositif de transformateur piézoélectrique mécaniquement intégré (100) comprend une section capacitive munie de première et seconde électrodes (7a, 7b) connectées à une sortie du circuit de modulation (18), dans lequel le côté secondaire (2) du deuxième sous-transformateur (103) comprend une section capacitive ayant des première et deuxième électrodes (10a, 10b) connectées à une entrée du démodulateur (40), et dans lequel le côté secondaire (3) du premier sous-transformateur (102) comprend une section capacitive ayant des première et deuxième électrodes (5a, 5b) connectées à l'entrée du circuit de modulation (18).

3. Capteur de tension (50) selon la revendication 1, comprenant en outre un circuit de démarrage (20) connecté de manière opérationnelle au dispositif de transformateur piézoélectrique mécaniquement intégré (100) pour initier le fonctionnement du transformateur.

4. Capteur de tension (50) selon la revendication 3, dans lequel le circuit de démarrage (20) est connecté au côté primaire, le premier sous-transformateur (102) est connecté au circuit de modulation (18) et le second sous-transformateur (103) est connecté à l'un des démodulateurs (40).

5. Capteur de tension (50) selon la revendication 4, dans lequel le côté primaire commun comprend une section capacitive munie de première et deuxième électrodes (7a, 7b) connectées à une sortie du circuit de modulation (18), dans lequel un côté secondaire du deuxième sous-transformateur comprend une section capacitive ayant des première et deuxième électrodes (10a, 10b) connectées à une entrée du démodulateur (40), et dans lequel un côté secondaire du premier sous-transformateur comprend une section capacitive ayant des première et deuxième électrodes (5a, 5b) connectées à la première entrée du circuit de modulation (18).

6. Capteur de tension (50) selon la revendication 5,
dans lequel le circuit de modulation (18) comprend un sous-circuit de commutation générant des fréquences (32) recevant le signal de tension de source (21) et un sous-circuit de connexion et de conditionnement de signal (75) recevant le signal porteur de modulation.

7. Capteur de tension (50) selon la revendication 5, dans lequel le circuit de modulation (18) comprend: un sous-circuit de commutation générant des fréquences (32) recevant le signal de tension de source (21); un circuit passif (74) ayant une entrée connectée au côté secondaire du premier sous-transformateur et ayant une sortie connectée à une ou plusieurs entrées du circuit de commutation générant des fréquences (21); et un circuit de réactance passif (73) ayant une entrée connectée à une sortie du circuit de commutation générant des fréquences (32) et au côté primaire commun du dispositif de transformateur piézoélectrique (100).

8. Capteur de tension (50) selon la revendication 7, dans lequel le circuit passif (74) est un court-circuit et le circuit de réactance passif (73) est un inducteur.

9. Capteur de tension (50) selon la revendication 8, dans lequel le circuit de commutation générant des fréquences (32) comprend un circuit en demi-pont.

10. Capteur de tension (50) selon la revendication 7, dans lequel le circuit de réactance passif (73) est un court-circuit, le circuit de réactance passif est un court-circuit, et le sous-circuit de commutation générant des fréquences (32) comprend un circuit en demi-pont.

11. Capteur de tension (50) selon la revendication 3, dans lequel le circuit de modulation (18) comprend: un sous-circuit de commutation générant des fréquences (32) recevant ledit signal de tension de source (21); un circuit de conditionnement de signal (75) ayant une entrée connectée à une première partie de ladite première sortie isolée galvaniquement, une deuxième partie de ladite première sortie isolée galvaniquement connectée à la terre, et une sortie connectée à une entrée dudit circuit de commutation générant des fréquences (32); et un circuit de réactance passif (73) ayant une entrée connectée à une sortie du circuit de commutation générant des fréquences (32) et ayant une sortie connectée au côté primaire commun.

12. Capteur de tension (50) selon la revendication 11, dans lequel le circuit de conditionnement du signal (75) est alimenté par le signal de tension de la source (21) ou par une source d'alimentation externe (55).

13. Capteur de tension (50) selon la revendication 11, dans lequel le circuit de réactance passif (73) est un inducteur et le sous-circuit de commutation générant des fréquences (32) comprend un circuit en demi-pont.

14. Capteur de tension (50) selon la revendication 3, comprenant en outre un circuit d'amplification linéaire (81) recevant et amplifiant le signal de tension de source (21).

15. Capteur de tension (50) selon la revendication 14, dans lequel le côté primaire commun a une section capacitive munie de première et seconde électrodes (7a, 7b), dans lequel le côté secondaire du second sous-transformateur a une section capacitive munie de première et seconde électrodes (10a), 10b) connectées à une entrée du démodulateur (40), et dans lequel un côté secondaire du premier sous-transformateur comprend a une section capacitive ayant des première et deuxième électrodes (5a, 5b) connectées au circuit de modulation (18).

16. Capteur de tension (50) selon la revendication 15, dans lequel le circuit de modulation (18) comprend: un sous-circuit de commutation générant des fréquences (32) recevant le signal de tension de source amplifié; un circuit passif (74) ayant une entrée connectée à l'une des première et deuxième électrodes (5a, 5b) du côté secondaire du premier sous-transformateur et ayant une sortie connectée à une entrée du circuit de commutation générant des fréquences (32); et un circuit de réactance passif (73) ayant une entrée connectée à une sortie du circuit de commutation générant des fréquences (32) et à l'une des première et deuxième électrodes (5a, 5b) du côté secondaire du premier transformateur, et ayant une sortie connectée à l'une des première et deuxième électrodes (7a, 7b) du côté primaire commun.

17. Capteur de tension (50) selon la revendication 14, dans lequel le circuit de modulation (18) comprend: un sous-circuit de commutation générant des fréquences (32) recevant le signal de tension de source amplifié; un circuit de conditionnement de signal (75) ayant une entrée connectée à l'une des première et deuxième électrodes (5a, 5b) du côté secondaire du premier sous-transformateur et ayant une sortie connectée à une entrée du circuit de commutation générant des fréquences (32); et un circuit de réactance passif (73) ayant une entrée connectée à une sortie du circuit de commutation générant des fréquences (32) et ayant une sortie connectée à une borne d'entrée (7a, 7b) du côté primaire commun, l'autre entrée du côté primaire commun étant connectée à la terre.

18. Capteur de tension (50) selon la revendication 17, dans lequel le circuit de conditionnement du signal (75) est alimenté par un signal de tension de source (21) ou par une source d'alimentation externe (55).

19. Capteur de tension (50) selon la revendication 3, dans lequel le circuit de démarrage (20) comprend des moyens pour s'éteindre automatiquement dès que le fonctionnement du transformateur est déclenché.

20. Capteur de tension (50) selon la revendication 3, dans lequel le circuit de démarrage (20) s'allume automatiquement pour initier le circuit auto-oscillant et s'éteint automatiquement une fois que le fonctionnement du transformateur est initié.
